# EUROPEAN PATENT APPLICATION

(11) **EP 4 783 785 A1**
(43) Date of publication of application: **29.07.2026**
(21) Application number: 26153422.6
(22) Date of filing: 22.01.2026
(51) Int. Cl.: H10F 77/20

(54) **LAYERED BODY, ELECTRONIC DEVICE, AND SOLAR CELL**

(30) Priority: 23.01.2025 JP 2025009579
(71) Applicant: KABUSHIKI KAISHA TOSHIBA, Kawasaki-shi, Kanagawa 212-0013 (JP)
(72) Inventor: YAMAMOTO, Takashi, Kawasaki-shi, Kanagawa (JP); SHIBASAKI, Soichiro, Kawasaki-shi, Kanagawa (JP); HONISHI, Yuya, Kawasaki-shi, Kanagawa (JP); SUGIMOTO, Kanta, Kawasaki-shi, Kanagawa (JP); WAKAMATSU, Kodai, Kawasaki-shi, Kanagawa (JP); YAMAMOTO, Kazushige, Kawasaki-shi, Kanagawa (JP)
(74) Representative: Hoffmann Eitle

(57) **Abstract**

A layered body according to an embodiment includes a substrate, a first intermediate layer provided on the substrate, and a first transparent electrode provided on the first intermediate layer. The refractive index of the first intermediate layer is lower than the refractive index of the substrate. The refractive index of the first intermediate layer is lower than the refractive index of the first transparent electrode.

## Description

### FIELD

Embodiments described herein relate generally to a layered body, an electronic device, a solar cell, a multi-junction solar cell, a solar cell module, and a photovoltaic power generation system.

### BACKGROUND

One of the new solar cells includes a solar cell that uses cuprous oxide (Cu₂O) as the light-absorbing layer. Cu₂O is a wide-gap semiconductor. Because Cu₂O is a safe and inexpensive material composed of copper and oxygen, which are abundantly available on the earth, it is expected that high-efficiency and low-cost solar cells can be realized.

### BRIEF DESCRIPTION OF THE DRAWINGS

FIG. 1 is a schematic cross-sectional diagram of a layered body according to an embodiment;
FIG. 2 is a schematic cross-sectional diagram of a layered body according to an embodiment;
FIG. 3 is a diagram explaining the analysis spots of the solar cell according to an embodiment;
FIG. 4 is a schematic cross-sectional diagram of a layered body according to an embodiment;
FIG. 5 is a schematic cross-sectional diagram of a layered body according to an embodiment;
FIG. 6 is a schematic cross-sectional diagram of an electronic device according to an embodiment;
FIG. 7 is a schematic cross-sectional diagram of an electronic device according to an embodiment;
FIG. 8 is a schematic cross-sectional diagram of an electronic device according to an embodiment;
FIG. 9 is a schematic cross-sectional diagram of a solar cell according to an embodiment;
FIG. 10 is a cross-sectional diagram of a multi-junction solar cell according to an embodiment;
FIG. 11 is a cross-sectional diagram of a multi-junction solar cell according to an embodiment;
FIG. 12 is a cross-sectional diagram of a multi-junction solar cell according to an embodiment;
FIG. 13 is an oblique perspective schematic diagram of a solar-cell module according to an embodiment;
FIG. 14 is an oblique perspective schematic diagram of a solar-cell module according to an embodiment;
FIG. 15 is a configuration diagram of a photovoltaic power generation system according to an embodiment;
FIG. 16 is a schematic diagram of a vehicle according to an embodiment;
FIG. 17 is a schematic diagram of a drone according to an embodiment;
FIG. 18 is a table of Examples;
FIG. 19 is a table of Examples;
FIG. 20 is a table of Examples;
FIG. 21 is a table of Examples;
FIG. 22 is a table of Examples;
FIG. 23 is a table of Examples;
FIG. 24 is a table of Examples;
FIG. 25 is a table of Examples;
FIG. 26 is a table of Examples; and
FIG. 27 is a table of Examples.

### DETAILED DESCRIPTION

A layered body according to an embodiment includes a substrate, a first intermediate layer provided on the substrate, and a first transparent electrode provided on the first intermediate layer. The refractive index of the first intermediate layer is lower than the refractive index of the substrate. The refractive index of the first intermediate layer is lower than the refractive index of the first transparent electrode.

Hereinafter, referring to the drawings, the embodiments of the present invention will be described in detail.

With reference to the drawings, a preferred embodiment of the present invention will be described in detail. Unless otherwise specifically indicated, the physical property values shown are those measured at 25 °C and 1 atm (atmospheric pressure). "Average" denotes an arithmetic mean. Each concentration is the average concentration in the region or layer concerned. In any layer, "a specific element is contained (included)" means that the element has been confirmed to exist, for example, by secondary ion mass spectrometry (SIMS); "a specific element is not contained" means that the element could not be confirmed, for example, by SIMS.

In the specification, "/" denotes the division sign. However, in the expression "or/and" the "/" means "or". In the specification, "·" and "*" denote multiplication. In the specification, "." denotes a decimal point.

The thickness and structure of members described in the specification can be known, for example, from one or more of images obtained by SEM (Scanning Electron Microscope), TEM (Transmission Electron Microscope), HAADF-STEM (High-Angle Annular Dark Field Scanning Transmission Electron Microscopy), and the like. The boundaries of the members described in the specification can be determined from one or more images obtained by scanning electron microscopy or transmission electron microscopy, SEM-EDS (Scanning Electron Microscopy with Energy Dispersive X-ray Spectroscopy) or TEM-EDX (Transmission Electron Microscopy with Energy Dispersive X-ray Spectroscopy), SIMS (Secondary Ion Mass Spectrometry), and the like. The composition of the members described in the specification can be determined by one SIMS, ICP-MS (Inductively Coupled Plasma Mass Spectrometry), SEM-EDX, TEM-EDX, or the like. The crystallinity of the members described in the specification can be evaluated, for example, from XRD (X-ray Diffraction), EBSD (Electron Backscatter Diffraction), images obtained by HAADF-STEM, SEM, TEM or the like. Materials included in the members described in the specification (crystal defects, bonding states, etc.) can be evaluated from HAADF-STEM, PL (Photoluminescence), XPS (X-ray Photoelectron Spectroscopy), or the like. These analysis methods are examples and do not negate the specific analytical methods described in the specification.

### (FIRST EMBODIMENT)

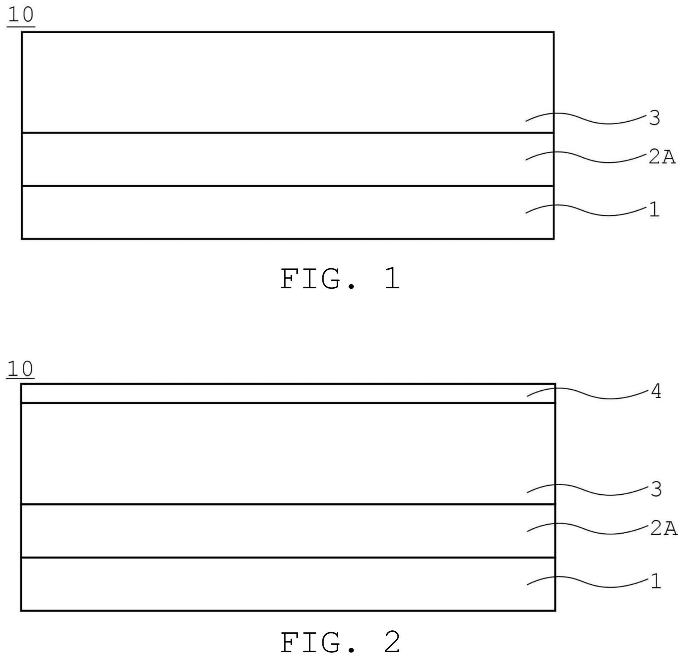

A first embodiment relates to a layered body. FIG. 1 shows a schematic cross sectional diagram of the layered body 10 of the first embodiment. The layered body 10 shown in FIG. 1 includes a substrate 1, a first intermediate layer 2A, and a first transparent electrode 3. It is preferable that light is incident from the side of the first transparent electrode 3 and that the light passes through the layered body 10. The layered body 10 may, for example, be used as an electrode of an optically transmissive electronic device.

The layered body 10 preferably has an average transmittance of 81 % or more for light having a wavelength of 600 nm or more and 1100 nm or less. The layered body 10 preferably has a maximum transmittance of 87 % or more for light having a wavelength of 600 nm or more and 1100 nm or less. The layered body 10 preferably has a minimum transmittance of 78 % or more for light having a wavelength of 600 nm or more and 1100 nm or less.

The layered body 10 preferably has an average reflectance of 17 % or less for light having a wavelength of 600 nm or more and 1100 nm or less. The layered body 10 preferably has a maximum reflectance of 19 % or less for a wavelength range of light between 600 nm and 1100 nm. The layered body 10 preferably has a minimum reflectance of 12 % or less for a wavelength range of light between 600 nm and 1100 nm.

The substrate 1 is a transparent substrate. The substrate 1 may be made of an acrylic, polyimide, polycarbonate, polyethylene terephthalate (PET), polypropylene (PP), a fluorine based resin (e.g., polytetrafluoroethylene (PTFE), perfluoro ethylene propylene copolymer (FEP), ethylene tetrafluoroethylene copolymer (ETFE), poly chlorotrifluoroethylene (PCTFE), perfluoroalkoxy alkane (PFA)), polyarylate, polysulfone, polyether sulfone, polyether imide or other organic based substrates, or of inorganic substrates such as soda lime glass, ultra clear glass, chemically strengthened glass or quartz. The substrate 1 may be a stacked (layered) member of the above substrates.

As the substrate 1, soda lime glass, ultra clear glass, chemically strengthened glass or quartz is preferred, with soda lime glass, ultra clear glass or quartz being more preferred.

The first intermediate layer 2A is provided between the substrate 1 and the first transparent electrode 3. The first intermediate layer 2A is electrical insulation; more specifically, it is an insulating layer.

The first intermediate layer 2A is an insulating layer having a resistivity of 10⁸ Ω·cm or more, and it is preferable that it has a resistivity of 10¹⁰ Ω·cm or more. The overall resistivity of the intermediate layer that is interposed between the substrate 1 and the first transparent electrode 3 including the first intermediate layer 2A, as well as the resistivity of each layer contained in the intermediate layer, is preferably 10⁸ Ω·cm or more, and more preferably 10¹⁰ Ω·cm or more.

It is preferable that the first intermediate layer 2A is a transparent insulating layer. It is preferable that the first intermediate layer 2A has an average transmittance of 95 % or more for light having a wavelength of 600 nm or more and 1100 nm or less.

It is preferable that the first intermediate layer 2A is mainly composed of SiO₂ or MgF₂. It is preferable that 75 wt % or more and 100 wt % or less of the first intermediate layer 2A is SiO₂ and MgF₂; it is more preferable that 85 wt % or more and 100 wt % or less of the first intermediate layer 2A is SiO₂ and MgF₂; and it is further more preferable that 95 wt % or more and 100 wt % or less of the first intermediate layer 2A is SiO₂ and MgF₂.

As an additive for adjusting the refractive index of the first intermediate layer 2A, one or more selected from a group comprising B₂O₃ and F is preferable.

By providing the intermediate layer that includes the first intermediate layer 2A between the substrate 1 and the first transparent electrode 3, reflection of the light incident from the side of the first transparent electrode 3 that occurs between the first transparent electrode 3 and the substrate 1, is reduced, thereby increasing the amount of light transmitted through the layered body 10.

The surface of the first intermediate layer 2A that faces the first transparent electrode 3 preferably has a high degree of flatness. The maximum value of the height difference between a convex portion of the first intermediate layer 2A and an adjacent concave portion (i.e., the thickness difference in the thickness direction of the first intermediate layer 2A between the convex portion and the adjacent concave portion) is preferably 0 nm or more and 100 nm or less; it is more preferable that the maximum height difference is 0 nm or more and 60 nm or less; and it is further more preferable that the maximum height difference is 0 nm or more and 20 nm or less.

It is preferable that the first intermediate layer 2A is a polycrystalline layer. The first intermediate layer 2A may include some amorphous phase, but it is preferable that the crystalline phase is the dominant phase.

The substrate 1 and the first transparent electrode 3 are stacked (layered) with one another through the intermediate layer that includes the first intermediate layer 2A. In other words, it is preferable that the substrate 1 and the first transparent electrode 3 are not in direct contact with each other. The surface of the substrate 1 that faces the first transparent electrode 3 is preferably not in direct contact with the surface of the first transparent electrode 3 that faces the substrate 1. The entirety of the surface of the first transparent electrode 3 on the substrate 1 side is preferably not in direct contact with the entirety of the surface of the substrate 1 of the first transparent electrode 3 side.

It is preferable that an interface exists between the substrate 1 and the first intermediate layer 2A (the intermediate layer). It is preferable that an interface exists between the amorphous phase (the substrate 1) and the crystalline phase (the first intermediate layer 2A, i.e., the intermediate layer).

The first transparent electrode 3 is positioned above the substrate 1 and is provided on the intermediate layer that includes the first intermediate layer 2A. In the diagram of the layered body 10 shown in FIG. 1, the first transparent electrode 3 is provided on the first intermediate layer 2A. The first transparent electrode 3 is a planar conductive film. The first transparent electrode 3 is a light transmissive conductive layer. It is preferable that the first transparent electrode 3 includes one or more layers of transparent conductive oxides. The transparent conductive oxide may include indium tin oxide (ITO), aluminum doped zinc oxide (AZO), boron doped zinc oxide (BZO), gallium doped zinc oxide (GZO), doped tin oxide, titanium doped indium oxide (ITiO), indium zinc oxide (IZO), indium gallium zinc oxide (IGZO), hydrogen doped indium oxide (IOH), and other semiconductor conductive films, without limitation to these examples. The transparent conductive oxides may be a multilayer comprising multiple films. As dopants for tin oxide type films, one or more elements selected from the group consisting of Zn, In, Si, Ge, Ti, Cu, Sb, Nb, Ta, W, Mo, F and Cl may be used, without limitation. It is preferable that the first transparent electrode 3 includes a doped tin oxide film in which one or more elements selected from the group consisting of Zn, In, Si, Ge, Ti, Cu, Sb, Nb, Ta, W, Mo, F and Cl are doped. In such doped tin oxide films, it is preferable that dopants are included in an amount of 10 atomic % or less relative to the tin in the tin oxide film As the first transparent electrode 3, a multi-layered film comprising the transparent conductive oxides and a metal film may be used. The metal film is preferably 1 nm or more and 2 µm or less in thickness, and the metal (including alloys) included in the metal film is not limited to Mo, Au, Cu, Ag, Al, Ta, W, etc. In addition, the first transparent electrode 3 preferably includes, between the transparent conductive oxides and the substrate 1, a dot type, line type or mesh type electrode (selected from the group consisting of metals, alloys, graphene, conductive nitrides and conductive oxides) with an aperture ratio of 50 % or more relative to the transparent conductive oxides. The dot type, line type or mesh type metal is not limited to Mo, Au, Cu, Ag, Al, Ta, W, etc. When a metal film is used for the first transparent electrode 3, a thickness of 5 nm or less is preferable from the viewpoint of optical transmittance. When line type or mesh type metal films are employed, the transmittance is ensured by the openings, so the foregoing thickness limitation may not apply.

Specific examples of the first transparent electrode 3 include a transparent electrode composed of an ITO film, and a stacked film comprising an ITO film and a doped tin oxide film in which the doped tin oxide film is positioned on the side facing the insulating layer.

The thickness of the first transparent electrode 3 is preferably 50 nm or more and 500 nm or less; more preferably 50 nm or more and 300 nm or less; further more preferably 75 nm or more and 200 nm or less; and still further more preferably 100 nm or more and 170 nm or less.

Next, the relationship among the refractive indices of the substrate 1, the first intermediate layer 2A and the first transparent electrode 3 will be described. When the first transparent electrode 3 is a multi-layered electrode, the refractive index of the portion of the first transparent electrode 3 that is positioned on the side of the first intermediate layer 2A is regarded as the refractive index of the first transparent electrode 3. The refractive index of the first intermediate layer 2A is preferably lower than the refractive index of the substrate 1 and also lower than the refractive index of the first transparent electrode 3. In the specification, refractive indices are those measured at a wavelength of 700 nm. It is preferable that inequality relationships of refractive indices are satisfied for wavelengths ranging from 600 nm to 1100 nm. The relationships described below are preferred requirements from the viewpoint of reducing the amount of light reflected by the layered body 10 when light is incident from the side of the first transparent electrode 3. Reflection in the layered body 10 includes reflection that occurs between the surface of the first transparent electrode 3 facing the substrate 1 and the surface of the substrate 1 facing the first transparent electrode 3.

The refractive index of the substrate 1 is preferably lower than that of the first transparent electrode 3 and higher than that of the first intermediate layer 2A.

The refractive index of the first intermediate layer 2A, which is the intermediate layer directly in contact with the first transparent electrode 3, is preferably lower than the refractive index of the first transparent electrode 3.

The refractive index of the first transparent electrode 3 is preferably 1.1 times or more that of the first intermediate layer 2A; more preferably 1.2 times or more; and further more preferably 1.3 times or more.

The refractive index of the first transparent electrode 3 is preferably 1.1 times or more and 1.5 times or less (preferably 1.45 times or less) that of the first intermediate layer 2A; more preferably 1.2 times or more and 1.5 times or less (preferably 1.45 times or less); and further more preferably 1.3 times or more and 1.5 times or less (preferably 1.45 times or less).

The refractive index of the substrate 1 is preferably 1.01 times or more that of the first intermediate layer 2A; more preferably 1.04 times or more; and further more preferably 1.1 times or more.

The refractive index of the substrate 1 is preferably 1.01 times or more and 1.3 times or less (preferably 1.25 times or less) that of the first intermediate layer 2A; more preferably 1.04 times or more and 1.3 times or less (preferably 1.25 times or less); and further more preferably 1.1 times or more and 1.3 times or less (preferably 1.25 times or less).

The difference between the refractive index of the first intermediate layer 2A and the refractive index of the first transparent electrode 3 ([refractive index of the first transparent electrode 3] minus [refractive index of the first intermediate layer 2A]) is preferably 0.36 or more and 0.60 or less; more preferably 0.40 or more and 0.60 or less; and further more preferably 0.50 or more and 0.60 or less.

The difference between the refractive index of the substrate 1 and the refractive index of the first intermediate layer 2A ([refractive index of the substrate 1] minus [refractive index of the first intermediate layer 2A]) is preferably 0.01 or more and 0.25 or less; more preferably 0.05 or more and 0.25 or less; and further more preferably 0.10 or more and 0.25 or less.

It is preferable that the difference between the refractive index of the first intermediate layer 2A and the refractive index of the first transparent electrode 3 is larger than the difference between the refractive index of the first intermediate layer 2A and the refractive index of the substrate 1. It is more preferable that the difference between the refractive index of the first intermediate layer 2A and the refractive index of the first transparent electrode 3 is 0.10 or more and 0.50 or less larger than the difference between the refractive index of the first intermediate layer 2A and the refractive index of the substrate 1.

It is preferable that the difference between the refractive index of the first intermediate layer 2A and the refractive index of the first transparent electrode 3 is 3 times or more and 25 times or less the difference between the refractive index of the first intermediate layer 2A and the refractive index of the substrate 1. It is more preferable that the difference between the refractive index of the first intermediate layer 2A and the refractive index of the first transparent electrode 3 is 4 times or more and 10 times or less the difference between the refractive index of the first intermediate layer 2A and the refractive index of the substrate 1.

When the difference between the refractive index of the substrate 1 and the refractive index of the first transparent electrode 3 is 0.15 or more and 0.55 or less, the effect of improving the transmittance of the layered body 10 by providing the first intermediate layer 2A becomes larger.

When the refractive index of the first transparent electrode 3 is 1.1 times or more and 1.4 times or less that of the substrate 1, the effect of improving the transmittance of the layered body 10 by providing the first intermediate layer 2A becomes larger.

The refractive index of the first intermediate layer 2A is preferably 1.30 or more and 1.50 or less; more preferably 1.30 or more and 1.47 or less; and further more preferably 1.30 or more and 1.40 or less.

The refractive index of the substrate 1 is preferably 1.46 or more and 1.54 or less; more preferably 1.50 or more and 1.54 or less; and further more preferably 1.52 or more and 1.54 or less.

The refractive index of the first transparent electrode 3 is preferably 1.60 or more and 2.15 or less; more preferably 1.65 or more and 2.15 or less; and further more preferably 1.67 or more and 2.15 or less.

A thin first intermediate layer 2A is preferable, but when the layer is too thin the transmittance-enhancing effect of the first intermediate layer 2A on the layered body 10 diminishes. Conversely, because thicker transparent layers absorb more light, an excessively thick first intermediate layer 2A also reduces the transmittance-enhancing effect. Accordingly, the thickness of the first intermediate layer 2A is preferably 0.2 times or more and 2.5 times or less that of the first transparent electrode 3; more preferably 1.4 times or more and 2.1 times or less; and further more preferably 1.45 times or more and 2.1 times or less.

A thin first intermediate layer 2A is preferable, but when the layer is too thin the transmittance-enhancing effect of the first intermediate layer 2A on the layered body 10 becomes small. Conversely, even for a transparent material, the thicker the layer the more light is absorbed, so when the first intermediate layer 2A is too thick the transmittance-enhancing effect of the first intermediate layer 2A on the layered body 10 also becomes small. Accordingly, the thickness of the first intermediate layer 2A is preferably 30 nm or more and 310 nm or less; more preferably 200 nm or more and 305 nm or less; and further more preferably 205 nm or more and 300 nm or less.

From the viewpoint of transmittance of the layered body 10, a thin substrate 1 is also preferable, but it is preferable to select a suitable thickness of the substrate 1 taking into account the formation process of the material formed on the first transparent electrode 3 and its mechanical strength. The thickness of the substrate 1 is, for example, 100 µm or more and 5 mm or less.

When no intermediate layer other than the first intermediate layer 2A is provided between the substrate 1 and the first transparent electrode 3, it is preferable that the surface of the first intermediate layer 2A that faces the substrate 1 is in direct contact with the surface of the substrate 1 that faces the first intermediate layer 2A, and that the surface of the first intermediate layer 2A that faces the first transparent electrode 3 is in direct contact with the surface of the first transparent electrode 3 that faces the first intermediate layer 2A.

The layered body 10 may further have an insulating film on the side of the first transparent electrode 3 opposite the substrate 1 side, if desired. FIG. 2 shows a schematic diagram of the layered body 10, and a schematic cross-sectional diagram of the layered body 10 that includes the insulating film 4.

The insulating film 4 is in direct contact with the first transparent electrode 3. The insulating film 4 is in direct contact with the surface of the first transparent electrode 3 that faces opposite the substrate 1 side (i.e., the surface of the first transparent electrode 3 that faces the insulating film 4). The first transparent electrode 3 preferably includes one or more transparent conductive oxides on the side that is nearest the insulating film 4, and the insulating film 4 is preferably in direct contact with the surface of those transparent conductive oxides that faces opposite the substrate 1 side (i.e., the surface of the transparent conductive oxides that is nearest the insulating film 4 and faces the insulating film 4).

The surface of the insulating film 4 that faces the first transparent electrode 3 side is preferably in direct contact with the first transparent electrode 3. The entire surface of the insulating film 4 that faces the first transparent electrode 3 is preferably in direct contact with the first transparent electrode 3.

It is preferable that the insulating film 4 covers 50 % or more and 100 % or less of the surface of the first transparent electrode 3 that faces opposite the substrate 1 side; more preferably it covers 95 % or more and 100 % or less; and further more preferably it covers 99 % or more and 100 % or less.

The insulating film 4 may cover the entire surface of the first transparent electrode 3 that faces opposite the substrate 1 side.

An insulating material for the insulating film 4 preferably includes one or more selected from the group consisting of SiO₂, Al₂O₃, SiN, SiON, and MgO. The insulating film 4 is a so-called glass or ceramic. The insulating film 4 is preferably composed of inorganic material. The insulating film 4 is preferably an amorphous film.

The insulating film 4 preferably includes one or more species selected from the group consisting of SiO₂, Na₂O, CaO, B₂O₃, Al₂O₃, SiN, SiON, and MgO, and the total amount of the species selected from that group that are present in the insulating film 4 is preferably 70 wt % or more and 100 wt % or less. In addition to the above oxides, the insulating film 4 may also include oxides such as Li₂O, K₂O, CaO, BaO, SrO, ZnO, ZrO₂, PbO, TiO₃, HfO₂, and Sb₂O₃.

The insulating film 4 is thinner than the substrate 1. The average thickness of the insulating film 4 is preferably 10⁻⁸ times or more and 10⁻³ times or less that of the substrate 1; more preferably 5×10⁻⁷ times or more and 5×10⁻³ times or less; and further more preferably 5×10⁻⁷ times or more and 5×10⁻⁴ times or less. The thickness of the insulating film 4 is preferably 1 nm or more and 50 nm or less; more preferably 1 nm or more and 30 nm or less; and further more preferably 3 nm or more and 20 nm or less.

The average thickness of the insulating film 4 is preferably 1 nm or more and 30 nm or less; it is also preferable that it be 1.5 nm or more; more preferably 3 nm or more and 25 nm or less; and further more preferably 5 nm or more and 20 nm or less.

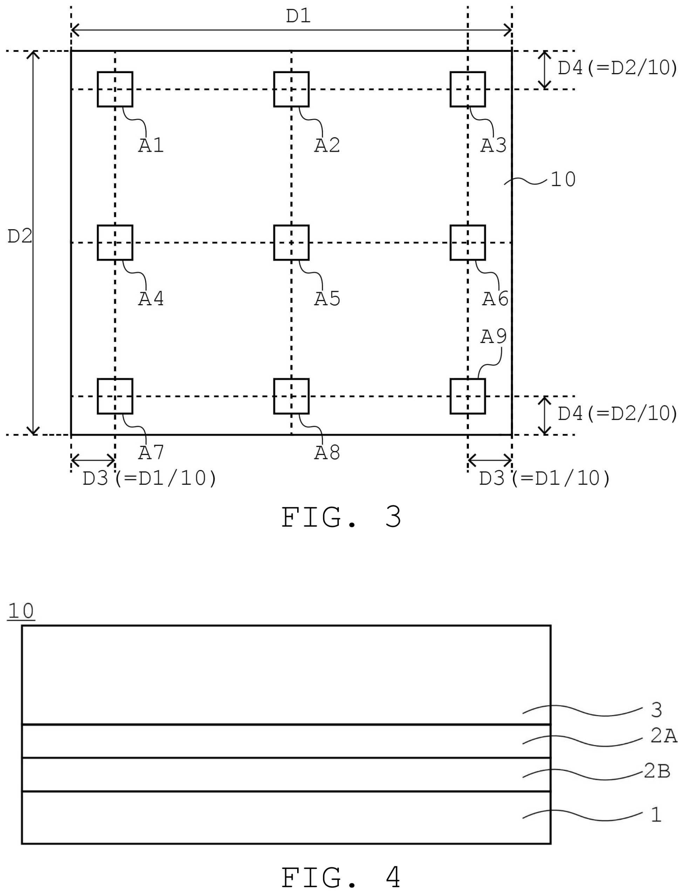

Composition analysis of the first intermediate layer 2A and other layers may be carried out, for example, by analyzing a set of evenly spaced analysis spots (A1-A9) that are distributed as densely as possible, as shown in the diagram of FIG. 3 which explains the analysis spots. The diagram of FIG. 3 is a schematic diagram of the layered body 10 as seen from the side of the first transparent electrode 3. When the composition of the layered body 10 is analyzed, D1 denotes the length of the layered body 10 in the width direction (the long-side direction) and D2 denotes the length in the depth direction (the short-side direction). By magnifying
the specimen 2 000 000× in a transmission electron microscope (TEM), a 100 nm × 100 nm region that includes the center of each analysis spot is observed in order to determine the thickness of the insulating film 4 and other parameters. Elemental mapping obtained by energy-dispersive X-ray spectroscopy (EDX) can also be used to derive composition. Furthermore, by analyzing the center of each spot in the thickness direction of the layered body 10 with X-ray photo-spectroscopy (XPS), the chemical-bonding state can be evaluated and the compounds of the elements contained in the insulating film 4 can be identified.

The thickness of the first intermediate layer 2A and other layers can be analyzed by observing a cross-section of the layered body 10 in the thickness direction. For a thin insulating film 4, its thickness is preferably determined by the following method. From a cross-sectional image, the area S [nm²] occupied by the insulating film 4 within a 10 nm-wide segment of the film is measured; dividing the area S by 10 yields the average thickness of the insulating film 4 within that 10 nm segment. The width of a single analysis spot is taken as 100 nm, and for each analysis spot ten thickness measurements are obtained. Repeating this for nine analysis spots provides ninety thickness data points for a single layered body 10. For example, stating that the thickness of the insulating film 4 is 1 nm or more and 50 nm or less means that all ninety measured thickness values lie within the range of 1 nm or more and 50 nm or less. The "average thickness of the insulating film 4" refers to the arithmetic mean of those ninety values; the "maximum thickness of the insulating film 4" refers to the largest of the ninety values. Portions where the insulating film 4 thickness is less than 0.1 nm are considered to be regions where the insulating film 4 is not present on the first transparent electrode 3. Consequently, the lower detection limit for the thickness of the insulating film 4 is set at 0.1 nm.

The side of the first transparent electrode 3 of the layered body 10 that faces the opposite side of the substrate 1 (i.e., the side of the insulating film 4 faces the opposite side of the first transparent electrode 3) is exposed.

The thicknesses and refractive indices of each layer comprised in the layered body 10 may be determined, for example, by spectroscopic ellipsometry.

For example, the first intermediate layer 2A can be formed on the substrate 1 by sputtering, the first transparent electrode 3 can be formed on the first intermediate layer 2A, and the insulating film 4 can be deposited on the first transparent electrode 3 by sputtering, atomic-layer-deposition (ALD), or other suitable methods to obtain the layered body 10.

The transmittance of the layered body 10 including the first transparent electrode 3 for light having a wavelength of 700 nm or more and 1000 nm or less is preferably 65 % or more, and the transmittance of the layered body 10 including the first transparent electrode 3 for light having a wavelength of 800 nm or more and 1000 nm or less is preferably 70 % or more.

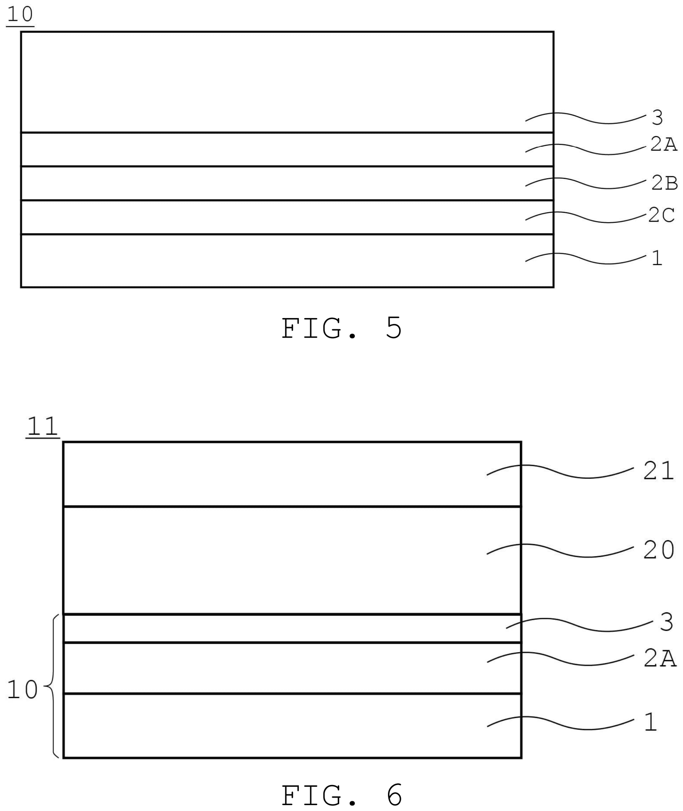

FIG. 4 and FIG. 5 show schematic cross-sectional diagrams of variation examples of the layered body 10. The variation examples of the layered body 10 include multiple intermediate layers. Even when the intermediate layers are multilayered, it is preferable that the optical properties of the layered body 10 still fall within the desirable ranges specified for the single-layer first intermediate layer 2A configuration shown in FIG. 1.

In the schematic diagram of FIG. 4, the layered body 10 includes, as intermediate layers, the first intermediate layer 2A and a second intermediate layer 2B. The second intermediate layer 2B is a light-transmissive material having a higher refractive index than that of the first intermediate layer 2A. The second intermediate layer 2B is positioned between the first intermediate layer 2A and the substrate 1. It is preferable that a layer which is the same as the second intermediate layer 2B or a layer which is analogous to the second intermediate layer 2B is not present between the first intermediate layer 2A and the first transparent electrode 3.

The second intermediate layer 2B is provided between the substrate 1 and the first transparent electrode 3. The second intermediate layer 2B is an insulator; more specifically, it is a laminar insulator.

The second intermediate layer 2B is an insulating layer having a resistivity of 10⁸ Ω·cm or more, and it is preferable that it have a resistivity of 10¹⁰ Ω·cm or more. The overall resistivity of the intermediate layer that includes the second intermediate layer 2B and the resistivity of layers which are interposed between the substrate 1 and the first transparent electrode 3, are preferably 10⁸ Ω·cm or more; more preferably 10¹⁰ Ω·cm or more.

The second intermediate layer 2B is preferably a transparent insulating layer. It is preferable that the second intermediate layer 2B have an average transmittance of 80 % or more for light having a wavelength of 600 nm or more and 1100 nm or less.

It is preferable that the second intermediate layer 2B includes Al₂O₃, ZrO₂, TiO₂, and SiO₂ as a main component. It is preferable that 75 wt % or more and 100 wt % or less of the second intermediate layer 2B be Al₂O₃, ZrO₂, TiO₂ and SiO₂; more preferably that 85 wt % or more and 100 wt % or less be Al₂O₃, ZrO₂, TiO₂, and Nb₂O₅; and further more preferably that 95 wt % or more and 100 wt % or less be Al₂O₃, ZrO₂, TiO₂, and SiO₂.

As additives for adjusting the refractive index of the second intermediate layer 2B, one or more species selected from the group consisting of Al₂O₃, TiO₂ and ZrO₂, are preferable.

By providing an intermediate layer that includes the first intermediate layer 2A and the second intermediate layer 2B between the substrate 1 and the first transparent electrode 3, reflection between the first transparent electrode 3 and the substrate 1 where light incident from the side of the first transparent electrode 3 can be reduced, thereby increasing the amount of light transmitted through the layered body 10.

The surface of the second intermediate layer 2B that faces the first transparent electrode 3 is preferably a highly flat surface. The maximum height difference between a convex portion of the second intermediate layer 2B and an adjacent concave portion (i.e., the thickness difference in the thickness direction of the second intermediate layer 2B between the convex portion and the adjacent concave portion) is preferably 0 nm or more (more than 0 nm) and 100 nm or less; more preferably 0 nm or more (more than 0 nm) and 60 nm or less; and further more preferably 0 nm or more (more than 0 nm) and 20 nm or less.

It is preferable that the second intermediate layer 2B be a polycrystalline layer. The second intermediate layer 2B may include some amorphous phase, but it is preferable that the crystalline phase be the dominant phase.

The refractive index of the second intermediate layer 2B is preferably 1.1 times or more and 1.7 times or less that of the first intermediate layer 2A; more preferably 1.1 times or more and 1.6 times or less; and further more preferably 1.1 times or more and 1.5 times or less.

The refractive index of the substrate 1 is preferably 0.65 times or more and 0.80 times or less that of the second intermediate layer 2B; more preferably 0.70 times or more and 0.80 times or less; and further more preferably 0.75 times or more and 0.80 times or less.

The refractive index of the first transparent electrode 3 is preferably 0.7 times or more and 1.3 times or less of the refractive index of the second intermediate layer 2B; more preferably 0.8 times or more and 1.3 times or less; and further more preferably 0.9 times or more and 1.3 times or less.

The refractive index difference between the first intermediate layer 2A and the second intermediate layer 2B is preferably 0.1 or more and 1.0 or less; more preferably 0.1 or more and 0.7 or less; and further more preferably 0.1 or more and 0.5 or less.

The refractive index difference between the substrate 1 and the second intermediate layer 2B is preferably 0.1 or more and 0.8 or less; more preferably 0.1 or more and 0.7 or less; and further more preferably 0.1 or more and 0.5 or less.

When the refractive index difference between the substrate 1 and the first intermediate layer 2A is 0.01 or more and 0.25 or less, the effect of improving the transmittance of the layered body 10 by providing the first intermediate layer 2A becomes larger.

The refractive index of the second intermediate layer 2B is preferably 1.6 or more and 2.3 or less; more preferably 1.6 or more and 2.1 or less; and further more preferably 1.6 or more and 2.0 or less.

The second intermediate layer 2B is preferably a thin layer, but when the layer is too thin, the effect of improving the transmittance of the layered body 10 by providing the second intermediate layer 2B becomes small. Also, even for transmissive members, the thicker the member the more light is absorbed, so when the thickness of the second intermediate layer 2B is too large, the effect of improving the transmittance of the layered body 10 by providing the second intermediate layer 2B becomes small. Accordingly, the thickness of the second intermediate layer 2B is preferably 0.1 times or more and 0.6 times or less of the thickness of the first transparent electrode 3; more preferably 0.1 times or more and 0.5 times or less; and further more preferably 0.1 times or more and 0.4 times or less. In addition, the thickness of the second intermediate layer 2B is preferably 0.05 times or more and 0.35 times or less of the thickness of the first intermediate layer 2A; more preferably 0.05 times or more and 0.30 times or less; and further more preferably 0.05 times or more and 0.25 times or less. Moreover, the total thickness of the first intermediate layer 2A and the second intermediate layer 2B (the total thickness of all intermediate layers interposed between the substrate 1 and the first transparent electrode 3) is preferably 1.40 times or more and 2.7 times or less of the thickness of the first transparent electrode 3; more preferably 1.50 times or more and 2.60 times or less; and further more preferably 1.55 times or more and 2.50 times or less.

It is preferable that the intermediate layers other than the first intermediate layer 2A have a thickness of 100 nm or less (for example, the total thickness of the second intermediate layer 2B and a third intermediate layer 2C is 100 nm or less).

The thickness of the intermediate layer having a higher refractive index than the first intermediate layer 2A (for example, the second intermediate layer 2B) is preferably thinner than the thickness of the first intermediate layer 2A, and it is preferable that it is at least 10 nm thinner than the thickness of the first intermediate layer 2A.

The second intermediate layer 2B is preferably a thin layer, but when the layer is too thin, the effect of improving the transmittance of the layered body 10 by providing the second intermediate layer 2B becomes small. Also, even for transmissive members, the thicker the member the more light is absorbed, so when the thickness of the second intermediate layer 2B is too large, the effect of improving the transmittance of the layered body 10 by providing the second intermediate layer 2B becomes small. Accordingly, the thickness of the second intermediate layer 2B is preferably 15 nm or more and 90 nm or less; more preferably 15 nm or more and 75 nm or less; and further more preferably 15 nm or more and 60 nm or less. Accordingly, the total thickness of the first intermediate layer 2A and the second intermediate layer 2B (the total thickness of all intermediate layers interposed between the substrate 1 and the first transparent electrode 3) is preferably 45 nm or more and 395 nm or less; more preferably 215 nm or more and 375 nm or less; and further more preferably 220 nm or more and 360 nm or less.

The layered body 10 shown in the diagram of FIG. 5 includes, as intermediate layers, the first intermediate layer 2A, the second intermediate layer 2B, and the third intermediate layer 2C. The third intermediate layer 2C possesses physical properties that include the optical characteristics described for the first intermediate layer 2A. The third intermediate layer 2C is located between the second intermediate layer 2B and the substrate 1. It is preferable that a layer which is as same as the third intermediate layer 2C or a layer which is analogous to the third intermediate layer 2C is not present between the first intermediate layer 2A and the first transparent electrode 3.

The third intermediate layer 2C is preferably a thin layer, but when the layer is too thin, the effect of improving the transmittance of the layered body 10 by providing the third intermediate layer 2C becomes small. Also, even for transmissive members, the thicker the member the more light is absorbed, so when the thickness of the third intermediate layer 2C is too large, the effect of improving the transmittance of the layered body 10 by providing the third intermediate layer 2C becomes small. Accordingly, the thickness of the third intermediate layer 2C is preferably 0.1 times or more and 0.5 times or less of the thickness of the first transparent electrode 3; more preferably 0.1 times or more and 0.4 times or less; and further more preferably 0.1 times or more and 0.3 times or less. In addition, the thickness of the third intermediate layer 2C is preferably 0.05 times or more and 0.30 times or less of the thickness of the first intermediate layer 2A; more preferably 0.05 times or more and 0.25 times or less; and further more preferably 0.05 times or more and 0.20 times or less. Moreover, the total thickness of the first intermediate layer 2A, the second intermediate layer 2B and the third intermediate layer 2C (the thickness of the intermediate layers interposed between the substrate 1 and the first transparent electrode 3) is preferably 1.5 times or more and 3.20 times or less of the thickness of the first transparent electrode 3; more preferably 1.60 times or more and 3.00 times or less; and further more preferably 1.65 times or more and 2.80 times or less.

The third intermediate layer 2C is preferably a thin layer, but if the layer is too thin, the effect of improving the transmittance of the layered body 10 by providing the third intermediate layer 2C becomes small. Also, even for transmissive members, the thicker the member the more light is absorbed, so if the thickness of the third intermediate layer
2C is too large, the effect of improving the transmittance of the layered body 10 by providing the third intermediate layer 2C becomes small. Accordingly, the thickness of the third intermediate layer 2C is preferably 15 nm or more and 75 nm or less; more preferably 15 nm or more and 60 nm or less; and further more preferably 15 nm or more and 45 nm or less. Accordingly, the total thickness of the first intermediate layer 2A, the second intermediate layer 2B and the third intermediate layer 2C (the thickness of the intermediate layers interposed between the substrate 1 and the first transparent electrode 3) is preferably 110 nm or more and 465 nm or less; more preferably 180 nm or more and 435 nm or less; and further more preferably 230 nm or more and 390 nm or less.

The number of repetitions in which the first intermediate layer 2A (or the third intermediate layer 2C) and the second intermediate layer 2B are stacked may be 2 or more. When the number of repetitions is large, reflection at the interfaces may cause the transmittance of the layered body 10 to decrease. Therefore, the number of repetitions in which the first intermediate layer 2A (or the third intermediate layer 2C) and the second intermediate layer 2B are stacked is preferably 3 or less (the total number of layers in the intermediate layer is 6 or less).

### (Second Embodiment)

A second embodiment relates to an electronic device. The electronic device of the second embodiment includes the layered body 10 and a liquid-crystal layer, a light-emitting layer or a semiconductor layer provided on the first transparent electrode 3 of the layered body 10 or on the insulating film 4. By forming a semiconductor layer, etc., on the insulating film 4, the thickness of the insulating film 4 of the second embodiment changes to a thickness different from that of the insulating film 4 described in the first embodiment. The insulating film 4 of the first embodiment does not have a thin portion and a thick portion as the insulating film 4 of the second embodiment does, but the insulating film 4 of the second embodiment has a thin portion and a thick portion. The thickness of the insulating film 4 of the first embodiment is different from the thickness of the insulating film 4 of the second embodiment.

FIG. 6 shows a cross-sectional diagram of an electronic device 11 having a liquid-crystal layer 20. The electronic device 11 includes the layered body 10, the liquid-crystal layer 20 and an electrode 21. The electronic device 11 is, for example, a display. The liquid-crystal layer 20 is positioned between the first transparent electrode 3 of the layered body 10 and an electrode 21 (or between the insulating film 4 and the electrode 21). The liquid-crystal layer 20, for example, includes liquid crystal sandwiched between alignment films. The liquid-crystal layer 20 is electrically connected to the first transparent electrode 3 of the layered body 10. The layered body 10 is suitable as a substrate having electrodes for a display.

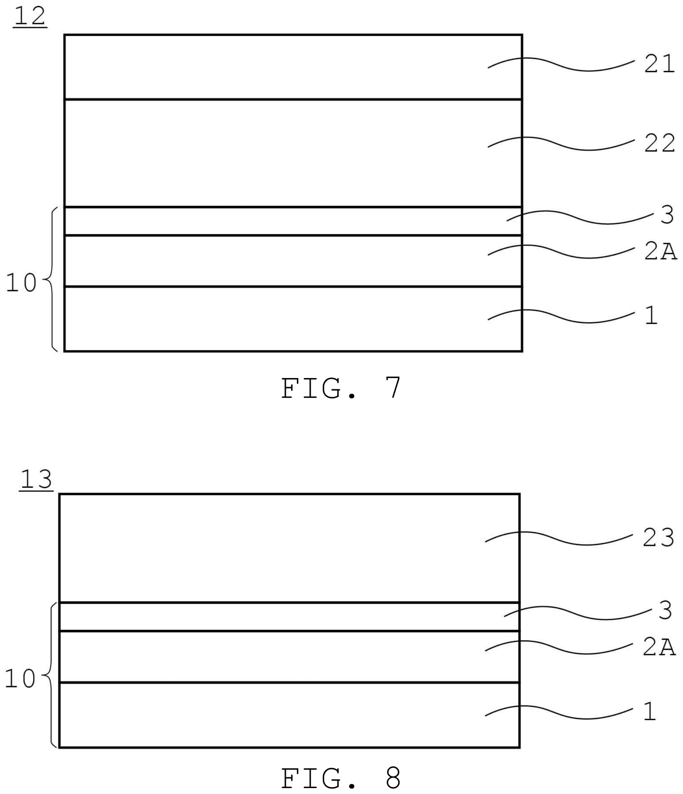

FIG. 7 shows a cross-sectional diagram of an electronic device 12 having a light-emitting layer 22. The electronic device 12 includes the layered body 10, the light-emitting layer 22 and an electrode 21. The electronic device 12 is, for example, a display. The light-emitting layer 22 is positioned between the first transparent electrode 3 of the layered body 10 and the electrode 21 (or between the insulating film 4 and the electrode 21). The light-emitting layer 22, for example, includes a polymer light-emitting layer and a hole-injection layer. The polymer light-emitting layer or the hole-injection layer of the light-emitting layer 22 is electrically connected to the first transparent electrode 3 of the layered body 10. The layered body 10 is suitable as a substrate having electrodes for a display.

FIG. 8 shows a cross-sectional diagram of an electronic device 13 having a semiconductor layer 23. The electronic device 13 includes the layered body 10 and the semiconductor layer 23. The electronic device 13 is, for example, used in a semiconductor apparatus that includes a solar cell. The semiconductor layer 23, for example, includes a compound semiconductor. The semiconductor layer 23 is electrically connected to the first transparent electrode 3 of the layered body 10. The layered body 10 is suitable as a substrate having electrodes for a semiconductor device.

From the second embodiment onward, the insulating film 4 includes at least one portion that has a thin portion having a thickness that allows current to flow in the thickness direction of the layered body 10 structure. The liquid-crystal layer 20 of electronic device 11 is electrically connected to the first transparent electrode 3. The light-emitting layer 22 of electronic device 12 is electrically connected to the first transparent electrode 3. The semiconductor layer 23 of the electronic device 13 is electrically connected to the first transparent electrode 3.

The insulating film 4 is a film including an insulating material that is provided on the first transparent electrode 3. The insulating film 4 is at least partially electrically conductive. The thickness direction of the insulating film 4 is the stacking direction of the insulating film 4 and the liquid-crystal layer 20, the light-emitting layer 22 or the semiconductor layer 23.

The insulating film 4 is in direct contact with the first transparent electrode 3. The insulating film 4 is in direct contact with the surface opposite the substrate 1 side of the first transparent electrode 3 (the surface of the first transparent electrode 3 that faces the insulating film 4). The first transparent electrode 3, on the side most adjacent to the insulating film 4, includes a layer of transparent conductive oxide, and it is preferable that the insulating film 4 is in direct contact with the surface of the layer of the transparent conductive oxide on the side opposite the substrate 1 where the layer of the transparent conductive oxide is on the side most adjacent to the insulating film 4 (i.e., the insulating film 4 is in direct contact with the surface of the layer of the transparent conductive oxide located on the side most adjacent to the insulating film 4 that faces the insulating film 4).

The side of the insulating film 4 that faces the first transparent electrode 3 is preferably in direct contact with the first transparent electrode 3. The entire side of the insulating film 4 that faces the first transparent electrode 3 is preferably in direct contact with the first transparent electrode 3.

The insulating film 4 is preferably configured to cover 50 % or more and 100 % or less of the surface of the first transparent electrode 3 that is opposite the substrate 1 side, covering 95 % or more and 100 % or less is more preferable, and covering 99 % or more and 100 % or less is further more preferable.

The insulating film 4 can cover the entire surface of the first transparent electrode 3 that is opposite the substrate 1 side.

It is considered that electricity flows through the thin portions of the insulating film 4 by the tunnel effect. The insulating film 4 also includes thick portions, and the thick portions have lower electrical conductivity than the thin portions. The thick portions are considered to function as a barrier layer for the first transparent electrode 3.

### (THIRD EMBODIMENT)

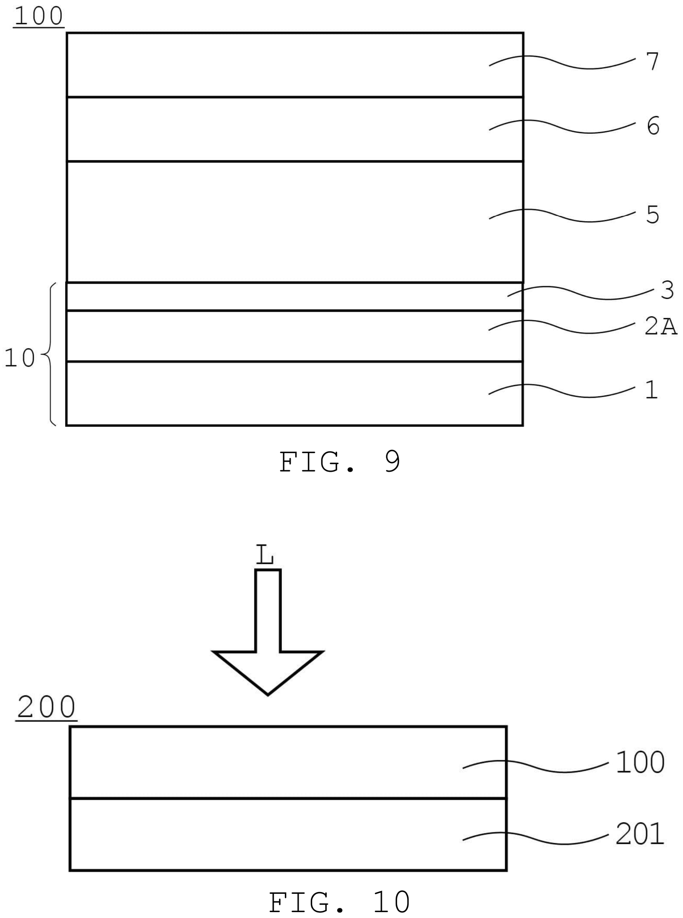

A third embodiment relates to a solar cell. A solar cell is a specific example of an electronic device. FIG. 9 shows a schematic cross-sectional diagram of a solar cell 100 according to the third embodiment. As shown in the figure, the solar cell 100 of the embodiment comprises the layered body 10 that includes the substrate 1, the first intermediate layer 2A (the intermediate layer comprising the first intermediate layer 2A and the second intermediate layer 2B; or the first intermediate layer 2A, the second intermediate layer 2B, and the third intermediate layer 2C), the first transparent electrode 3 (which is the first electrode) and optionally an insulating film 4, a p-type light-absorbing layer 5, an n-type layer 6, and a second transparent electrode 7 (which is the second electrode). The insulating film 4 is the insulating film 4 of the second embodiment which has the thin portion and the thick portion. The first transparent electrode 3 functions as the p-type electrode. Intermediate layers that are not shown may be present between the p-type light-absorbing layer 5 and the n-type layer 6, and between the n-type layer 6 and the second transparent electrode 7. Solar radiation may be incident from either the second transparent electrode 7 side or the first transparent electrode 3 side, but incidence from the second transparent electrode 7 side is more preferable. Because the solar cell 100 of the embodiment is a transmission-type solar cell, it is preferable to use it on the top-cell side (light-incident side) of a multi-junction solar cell. The description below refers to the configuration shown in FIG. 9; the same description applies to a configuration in which the substrate 1 is provided on the second transparent electrode 7 side, except that the position of the substrate 1 is different. In the embodiment, light enters from the second transparent electrode 7 side toward the first transparent electrode 3 side.

When the solar cell 100 of the embodiment employs transmissive-type electrodes for the first transparent electrode 3 and the second transparent electrode 7, the transmittance of light in the wavelength band of 700 nm or more and 1200 nm or less is high, and the device is a transmissive-type solar cell which may have a reddish (red-brown), yellow or orange color.

The p-type light-absorbing layer 5 is, overall, a p-type semiconductor layer. The p-type light-absorbing layer 5 is provided on the first transparent electrode 3. It is preferable that the p-type light-absorbing layer 5 be in direct contact with the first transparent electrode 3 or be in direct contact with both the first transparent electrode 3 and the insulating film 4. The p-type light-absorbing layer 5 is positioned either between the first transparent electrode 3 and the n-type layer 6, or between the insulating film 4 and the n-type layer 6. When the p-type light-absorbing layer 5 is in direct contact with the n-type layer 6, it is preferable that the p-type light-absorbing layer 5 form a p-n junction with the n-type layer 6. A compound-semiconductor layer is preferable for the p-type light-absorbing layer 5. Semiconductor layers containing compounds having a chalcopyrite structure such as CIGS or CGS, or compounds having a cuprite (cuprous oxide) structure such as cuprous oxide, are preferable for the p-type light absorbing layer 5. Preferably, the p-type light-absorbing layer 5 mainly comprises a cuprous oxide compound. The cuprous oxide compound is preferably of the cuprite crystal structure. Below, a solar cell in which the p-type light-absorbing layer 5 contains a cuprous oxide compound is described as an example. When other compounds are used for the p-type light-absorbing layer 5, it is preferable to adopt the layered body 10 of the first embodiment and a structure suitable for each respective compound.

It is preferable that the p-type light-absorbing layer 5 be a semiconductor layer containing a cuprous oxide compound. It is preferable that the p-type light-absorbing layer 5 be a polycrystalline form of the cuprous oxide compound. The p-type light-absorbing layer 5 may include, as a minor impurity, one or more sub-oxides of copper selected from the group comprising copper (Cu), copper oxide (CuO) and copper hydroxide (Cu(OH)₂).

When the total of all elements in the p-type light-absorbing layer 5 except for oxygen is taken as 100 atomic%, the copper element contained in the p-type light-absorbing layer 5 is preferably 90 atomic% or more and less than 100 atomic%, preferably 95 atomic% or more and less than 100 atomic%, more preferably 98 atomic% or more and less than 100 atomic%, and further more preferably 99 atomic% or more and less than 100 atomic%.

When the total of all elements in the p-type light-absorbing layer 5 except for oxygen is taken as 100 atomic%, the copper element contained in the p-type light-absorbing layer 5 is preferably 90 atomic% or more and 99.9 atomic% or less, preferably 95.0 atomic% or more and 99.9 atomic% or less, more preferably 98 atomic% or more and 99.9 atomic% or less, and further more preferably 99.0 atomic% or more and 99.9 atomic% or less.

The cuprous oxide compound includes copper, oxygen, and, optionally, one or more elements represented by M1. The elements represented by M1 are preferably selected from the group consisting of Cl, F, Br, I, Sn, Sb, Ag, Li, Na, K, Cs, Rb, Al, In, Zn, Mg, Ga, Si, Ge, N, P, B, Ti, Hf, Zr and Ca.

When the amount of copper atoms in the cuprous oxide compound is set to 1, the amount of oxygen atoms is preferably 0.48 or more and 0.56 or less. When the amount of oxygen relative to copper is high, the ratio of copper oxide contained in the cuprous oxide compound becomes high, the band-gap narrows, and the transmittance of the p-type light-absorbing layer 5 decreases, which is undesirable. When the amount of oxygen relative to copper is low, the ratio of copper contained in the cuprous oxide compound becomes high, and the transmittance decreases, which is also undesirable. Moreover, when the oxygen-to-copper ratio does not satisfy the above range, it becomes difficult for the cuprous oxide compound to have a cuprite crystal structure.

It is preferable that 95 wt% or more and less than 100 wt% of the p-type light-absorbing layer 5 be the cuprous oxide compound, 98 wt% or more and less than 100 wt% being the cuprous oxide compound is more preferable, and 99 wt% or more and 100 wt% or less being the cuprous oxide compound is further more preferable. The p-type light-absorbing layer 5 can be composed of 100 wt% cuprous oxide compound.

When the p-type light-absorbing layer 5 includes few hetero-phases and exhibits good crystallinity, its transmittance may be high, which is preferable. By means such as incorporating elements other than Cu and O into the p-type light-absorbing layer 5, the band-gap of the p-type light-absorbing layer 5 can be adjusted. The band-gap of the p-type light-absorbing layer 5 is preferably 2.0 eV or more and 2.2 eV or less. When the band-gap lies in this range, a solar cell that uses Si as the light-absorbing layer can be employed as a bottom cell, and the present solar cell can be used as a top cell of a multi-junction solar cell, thereby allowing efficient utilization of sunlight in both the top cell and the bottom cell. It is preferable that the p-type light-absorbing layer 5 includes Sn and/or Sb. The Sn or Sb in the p-type light-absorbing layer 5 may be added to the p-type light-absorbing layer 5 or may originate from the first transparent electrode 3. The Ga that is present in the p-type light-absorbing layer 5 is not included in the raw material used to deposit the p-type light-absorbing layer 5; it diffuses from the n-type layer 6 into the p-type light-absorbing layer 5. When other elements are used during the deposition of the n-type layer 6, those elements may also diffuse into the p-type light-absorbing layer 5.

The composition ratios mentioned above for the p-type light-absorbing layer 5 are the overall composition ratios of the p-type light-absorbing layer 5. In addition, the compound composition ratios mentioned above for the p-type light-absorbing layer 5 are preferably satisfied throughout the p-type light-absorbing layer 5.

The thickness of the p-type light-absorbing layer 5 is preferably 500 nm or more and 10 µm or less, and 750 nm or more and 7.0 µm or less is more preferable.

It is preferable that the p-type light-absorbing layer 5 have a p⁺ (p plus) region on the side facing the first transparent electrode 3.

It is preferable that the p-type light-absorbing layer 5 have a p⁻ (p minus) region on the side facing the n-type layer 6.

It is preferable that the p-type light-absorbing layer 5 have a p⁻ (p minus) region on the side facing the n-type layer 6 and a p⁺ (p plus) region on the side facing the first transparent electrode 3.

It is preferable that the p-type light-absorbing layer 5 be formed, for example, by sputtering. Specifically, a component on which the first transparent electrode 3 has been formed on the substrate 1 is heated to a temperature of 300 °C or more and 1000 °C or less, and the deposition is carried out at an oxygen partial pressure of 0.01 Pa or more and 4.8 Pa or less, with an oxygen flow rate of 0.02 µm/min or more and 20 µm/min or less. From the viewpoint of forming a highly transmissive, large-grain-size polycrystalline film, when the deposition rate is denoted by d, the oxygen partial pressure should satisfy 0.20 × d Pa or more and 1.00 × d Pa or less (for example, for high-temperature sputtering above 600 °C, 0.20 × d Pa or more and 0.50 × d Pa or less is more preferable; for low-temperature sputtering, 0.55 × d Pa or more and 1.00 × d Pa or less is more preferable). Moreover, the heating temperature is more preferable to be 600 °C or more and 850 °C or less. Elements represented by M1 may be added during deposition.

The n-type layer 6 is an n-type semiconductor layer. The n-type layer 6 is positioned between the p-type light-absorbing layer 5 and the second transparent electrode 7. It is preferable that the n-type layer 6 be provided on the p-type light-absorbing layer 5. The n-type layer 6 may, for example, be deposited by an ALD method.

It is preferable that the n-type layer 6 includes a compound (oxide) of Ga mainly. The n-type layer 6 may include other oxides mixed with a Ga-based oxide, may have other elements doped into a Ga-based oxide, or may be a mixture of a Ga-based oxide doped with other elements and other oxides. The n-type layer 6 may be a single layer or a multilayer. Among the metallic elements included in the n-type layer 6, it is preferable that Ga be present at 40 atom % or more, and it is more preferable that Ga be present at 50 atom % or more. The Ga-containing metallic elements in the n-type layer 6 may be inclined from the side of the p-type light-absorbing layer 5 toward the side of the second transparent electrode 7. When the n-type layer 6 is a multilayer semiconductor (for example, two layers), the layers are designated the first n-type layer and the second n-type layer from the side of the p-type light-absorbing layer 5. The element represented by M2 that is contained in the first n-type layer is preferably less than the amount of the element represented by M2 that is included in the second n-type layer.

It is preferable that the n-type layer 6 contain an oxide comprising Ga and an element represented by M2. A Ga-based oxide is, for example, an oxide that contains both the element represented by M2 and Ga. The n-type layer 6 preferably contains an oxide comprising Ga and at least one element M2 selected from the group consisting of H, Sn, Sb, Cu, Ag, Li, Na, K, Cs, Rb, Al, In, Zn, Mg, Si, Ge, N, B, Ti, Hf, Zr, Ca, Ce, La, Pr and Nd. When the n-type layer 6 is multilayered, for example, the n-type layer used for the first n-type layer preferably contains an oxide comprising Ga and at least one element M2 selected from the same group, in an amount of 90 wt% or more and 100 wt% or less. The Ga-based compound of the n-type layer 6 preferably has an average composition expressed as Gaₕ₁M2ᵢ₁Oⱼ₁, where h1, i1 and j1 satisfy 1.8 ≤ h1 ≤ 2.1, 0.0 ≤ i1 ≤ 0.2 and 2.9 ≤ j1 ≤ 3.1. In the case of a multilayer n-type layer 6, for example, the oxide used for the second n-type layer may be, for example, Sn-doped zinc oxide, other doped oxides, or zinc-based compound (oxide) including Sn or other additive metal element.

It is preferable that 90 wt% or more and 100 wt% or less of the n-type layer 6 be an oxide comprising M2 and Ga. It is more preferable that 95 wt% or more and 100 wt% or less of the n-type layer 6 be an oxide comprising M2 and Ga. It is further more preferable that 98 wt% or more and 100 wt% or less of the n-type layer 6 be a compound expressed as an oxide comprising M2 and Ga. The Cu contained in the n-type layer 6 does not originate from the raw material used to deposit the n-type layer 6; rather, Cu present in the p-type light-absorbing layer 5 diffuses into the n-type layer 6. When other elements are used during the deposition of the p-type light-absorbing layer 5, those elements may also diffuse into the n-type layer 6.

The film thickness of the n-type layer 6 is typically 3 nm or more and 100 nm or less. When the thickness of the n-type layer 6 is less than 3 nm, poor coverage of the n-type layer 6 may cause leakage current and degrade performance. When coverage is good, the thickness is not limited to the range above. When the thickness of the n-type layer 6 exceeds 50 nm, excessive resistivity of the n-type layer 6 may degrade performance, and reduced transmittance may lead to a decrease in short-circuit current. Accordingly, it is more preferable that the thickness of the n-type layer 6 be 3 nm or more and 20 nm or less, and it is further more preferable that the thickness be 5 nm or more and 20 nm or less.

The second transparent electrode 7 is an electrode on the side of the n-type layer 6 that possesses visible-light transmittance. The second transparent electrode 7 is provided on the light-incident side of the solar cell 100. It is preferable that the second transparent electrode 7 be provided on the n-type layer 6. An intermediate layer that is not shown may be provided between the n-type layer 6 and the second transparent electrode 7. An anti-reflection layer that is not shown may be provided on top of the second transparent electrode 7. The anti-reflection layer is placed on the light-incident side. It is preferable that the second transparent electrode 7 use transparent conductive oxides. The transparent conductive oxide used for the second transparent electrode 7 is preferably semiconductor conductive films selected from the group consisting of indium-tin oxide, aluminum-doped zinc oxide, boron-doped zinc oxide, gallium-doped zinc oxide, indium-doped zinc oxide, titanium-doped indium oxide, indium-gallium-zinc oxide and hydrogen-doped indium oxide. As dopants for oxide films such as zinc oxide, any one or more elements selected from the group consisting of In, Si, Ge, Ti, Cu, Sb, Nb, Ta, W, Mo, F and Cl may be used without particular limitation. To lower the resistance of the transparent conductive oxides, the second transparent electrode 7 may include mesh or line-shaped electrodes. The mesh or line-shaped electrodes may be composed of Mo, Au, Cu, Ag, Al, Ta, W or other suitable materials. Graphene may also be used for the second transparent electrode 7, and it is preferable that graphene be stacked with silver nanowires.

The thickness of the second transparent electrode 7 is determined by cross-sectional observation with an electron microscope or by a step-height measurement; although not particularly limited, it is typically 50 nm or more and 2 µm or less.

It is preferable that the second transparent electrode 7 be deposited, for example, by ALD or sputtering.

When a semiconductor layer including a perovskite-type compound is used as the power-generation layer, either a stack of p-type layer (hole transport layer) / perovskite semiconductor layer / n-type layer (electron transport layer) / second transparent electrode 7 on the layered body 10 may be employed, or a stack of n-type layer (electron transport layer) / perovskite semiconductor layer / p-type layer (hole transport layer) / second transparent electrode 7 on the layered body 10 may be employed. Solar cells that use a perovskite semiconductor layer are included in the solar cell of the second embodiment or the solar cell 100 of the third embodiment.

The composition of compounds such as the p-type light-absorbing layer 5 and the n-type layer 6, unless otherwise specified, refers to the average composition of the entire p-type light-absorbing layer 5 or n-type layer 6. For example, by analyzing analysis spots A1-A9 shown in FIG. 3 with secondary ion mass spectrometry (SIMS), the composition of each layer can be obtained.

### (FOURTH EMBODIMENT)

A fourth embodiment relates to a multi-junction solar cell. FIG. 10 shows a diagrammatic cross-section of a multi-junction solar cell 200 of the fourth embodiment. In FIG. 10, the multi-junction solar cell 200 includes, on the light-incident side where light L enters, the solar cell of the third embodiment (the first solar cell) 100 and a second solar cell 201. The band-gap of the light-absorbing layer of the second solar cell 201 is smaller than the band-gap of the p-type light-absorbing layer 5 of the solar cell 100 of the third embodiment. The multi-junction solar cell 200 of the embodiment also includes configurations in which three or more solar cells are stacked.

Because the band-gap of the p-type light-absorbing layer (cuprous oxide) 5 of the first solar cell 100 of the third embodiment is about 2.0 eV or more and 2.2 eV or less, it is preferable that the band-gap of the light-absorbing layer of the second solar cell 201 be 1.0 eV or more and 1.6 eV or less. As the light-absorbing layer of the second solar cell 201, it is preferable to select one or more compound semiconductor layers chosen from a group comprising high-In-content CIGS-type and CdTe-type compounds, and one selected from a group comprising crystalline silicon and perovskite-type compounds.

When the second solar cell 201 is a solar cell such as a back-contact Si solar cell that has a positive electrode and a negative electrode on its rear side, either the layered body 10 having a substrate 1 or the layered body 10 without a substrate 1 may be employed. In this case, the first intermediate layer 2A (intermediate layer) or the second intermediate layer 2B (the intermediate layer formed by stacking the first intermediate layer 2A and the second intermediate layer 2B) may be provided directly on the Si layer. It is preferable that the intermediate layer that is in direct contact with the Si layer be the second intermediate layer 2B rather than the first intermediate layer 2A. The intermediate layer located between the first transparent electrode 3 (which contains the first intermediate layer 2A) and the second solar cell 201 electrically isolates the first solar cell 100 and the second solar cell 201, with the intermediate layer interposed between them.

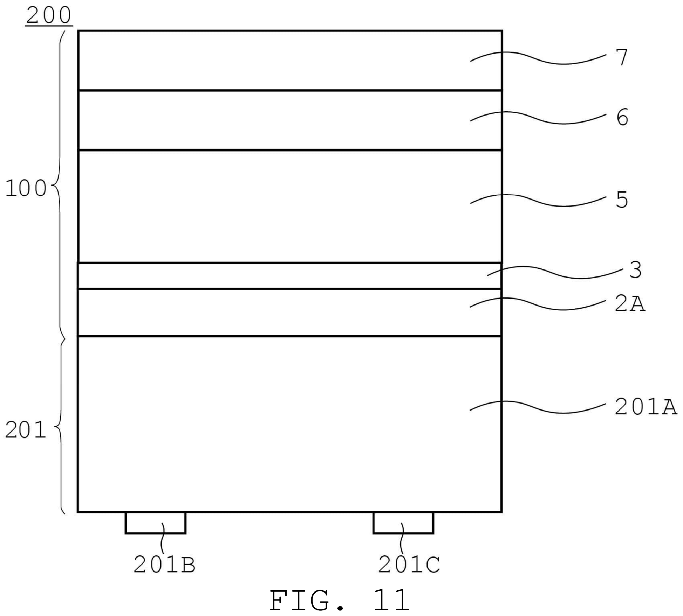

FIG. 11 shows an example of a conceptual cross-sectional diagram of a multi-junction solar cell 200 that uses a stacked body in which the substrate 1 is omitted, wherein the second solar cell 201 is a back-contact Si solar cell. The multi-junction solar cell 200 comprises, from the side of the second solar cell 201, the second intermediate layer 2B, the first intermediate layer 2A, the first transparent electrode 3, the p-type light-absorbing layer 5, the n-type layer 6 and the second transparent electrode 7 constituting the first solar cell 100, and also includes the second solar cell 201 comprising a semiconductor layer 201A, a first electrode 201B (which is a p-electrode or n-electrode) and a second electrode 201C (which is an n-electrode or p-electrode). The second intermediate layer 2B may be in direct contact with the second solar cell 201, or an additional intermediate layer may be provided between the second intermediate layer 2B and the semiconductor layer 201A of the second solar cell 201.

The relationship between the first intermediate layer 2A and the semiconductor layer 201A in this embodiment corresponds to the relationship between the first intermediate layer 2A and the substrate 1 in the first embodiment.

When the second intermediate layer 2B is provided between the first intermediate layer 2A and the semiconductor layer 201A, the relationship between the refractive index of the second intermediate layer 2B and the refractive indices of the other layers is applied to the relationship applicable to the first intermediate layer 2A. It is preferable that the refractive index of the second intermediate layer 2B be lower than the refractive index of the semiconductor layer 201A, more preferably at least 10 % lower than the refractive index of the semiconductor layer 201A, and further more preferably at least 30 % lower than the refractive index of the semiconductor layer 201A. When other intermediate layers exist between the first transparent electrode 3 and the semiconductor layer 201A, those intermediate layers should be judged, on the basis of refractive index, as being optically equivalent to either the first intermediate layer 2A or the second intermediate layer 2B, and each should satisfy the appropriate refractive index and thickness.

When the second solar cell 201 is a solar cell such as a Si solar cell that has electrodes on both its front (incident) side and its rear side, the first intermediate layer 2A (intermediate layer) may be placed directly on the electrode on the incident side. In this case, directly on the incident-side electrode one may provide either the first intermediate layer 2A (intermediate layer) or the second intermediate layer 2B (the intermediate layer formed by stacking the first intermediate layer 2A and the second intermediate layer 2B). The intermediate layer located between the first transparent electrode 3 (which includes the first intermediate layer 2A) and the second solar cell 201 electrically isolates the first solar cell 100 and the second solar cell 201, with the intermediate layer interposed between them.

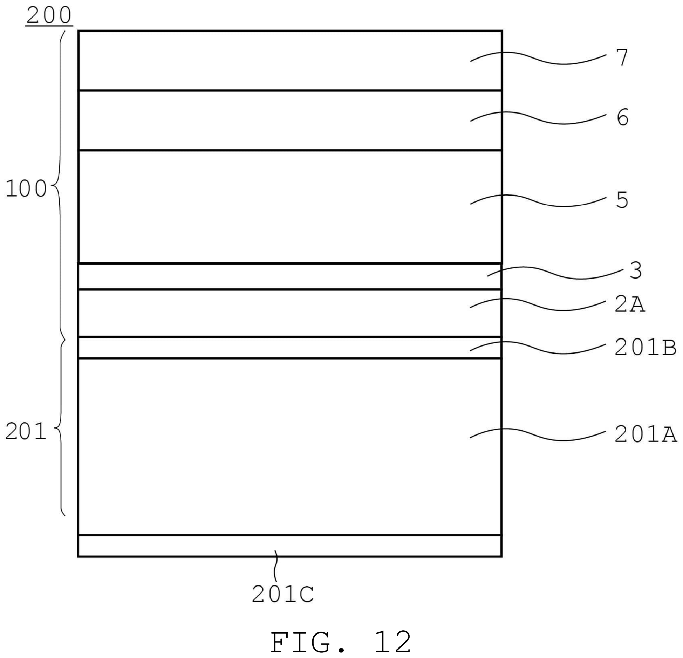

FIG. 12 shows a conceptual cross-sectional diagram of a multi-junction solar cell 200 in which the second solar cell 201 has electrodes on both sides and the substrate 1 is omitted. The multi-junction solar cell 200 comprises, from the side of the second solar cell 201, the first intermediate layer 2A, the first transparent electrode 3, the p-type light-absorbing layer 5, the n-type layer 6 and the second transparent electrode 7 constituting the first solar cell 100, and also includes the second solar cell 201 comprising a semiconductor layer 201A, a transparent first electrode 201B (which is a p-electrode or n-electrode), and a second electrode 201C (which is an n-electrode or p-electrode). The first intermediate layer 2A may be in direct contact with the second solar cell 201, or an additional intermediate layer may be provided between the first intermediate layer 2A and the semiconductor layer 201A of the second solar cell 201.

The relationship between the first intermediate layer 2A and the first electrode 201B in this embodiment corresponds to the relationship between the first intermediate layer 2A and the substrate 1 in the first embodiment.

When the second intermediate layer 2B is provided between the first intermediate layer 2A and the first electrode 201B, the relationship between the refractive index of the second intermediate layer 2B and the refractive indices of the other layers is applied to the relationship applicable to the first intermediate layer 2A. It is preferable that the relationship between the refractive index of the second intermediate layer 2B and the refractive index of the first electrode 201B correspond to the relationship between the refractive index of the second intermediate layer 2B and the refractive index of the substrate 1. When other intermediate layers exist between the first transparent electrode 3 and the semiconductor layer 201A, those intermediate layers should be judged, on the basis of refractive index, as being optically equivalent to either the first intermediate layer 2A or the second intermediate layer 2B, and each should satisfy the appropriate refractive index and thickness.

### (FIFTH EMBODIMENT)

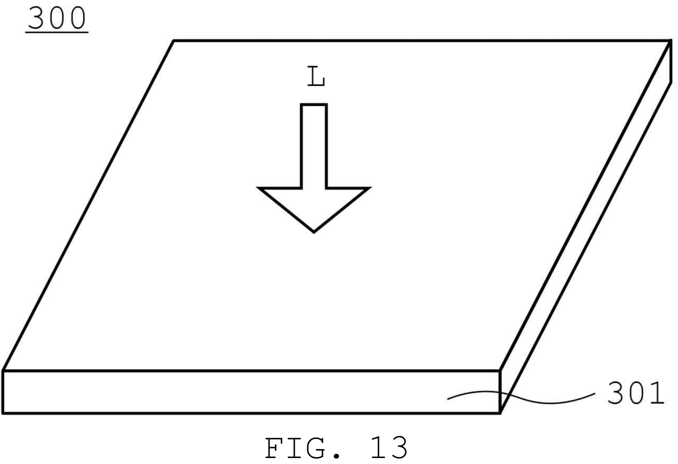

A fifth embodiment relates to a solar-cell module. FIG. 13 shows a perspective diagram of the solar-cell module 300 of the fifth embodiment. The solar-cell module 300 includes a first solar-cell module 301 that includes multiple solar cells 100, or a first solar-cell module 301 that includes multiple multi-junction solar cells 200. The solar-cell module 300 may also be installed on the light-incident side of a solar cell that has already been installed.

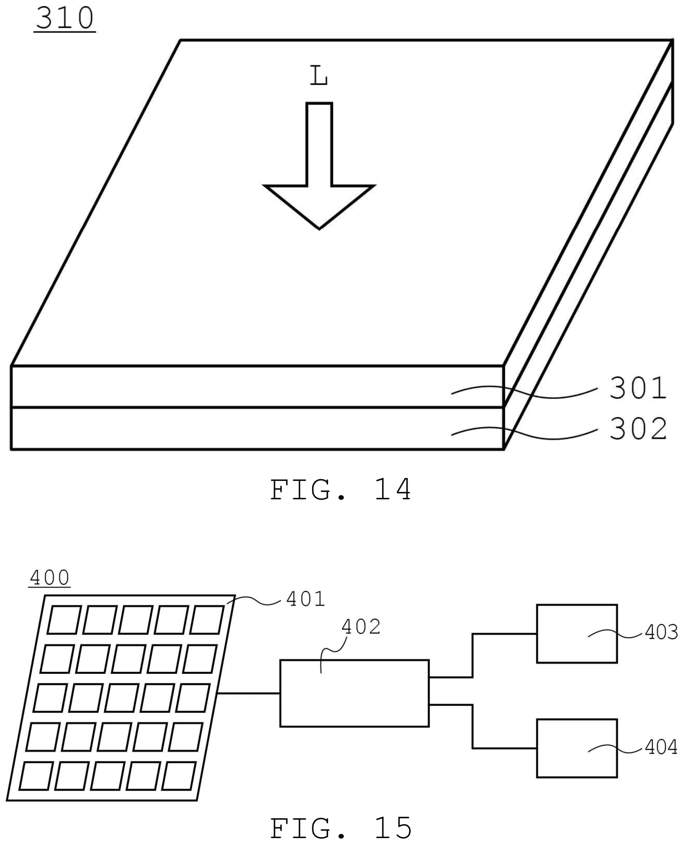

FIG. 14 shows a perspective diagram of the solar-cell module 310 of the fifth embodiment. The solar-cell module 310 is a solar-cell module formed by stacking a first solar-cell module 301, which contains multiple solar cells 100, and a second solar-cell module 302. The first solar-cell module 301 is positioned on the light-incident side where light L enters. The second solar-cell module 302 preferably uses a second solar cell 201.

### (SIXTH EMBODIMENT)

A sixth embodiment relates to a photovoltaic power generation system. The solar cell module of the sixth embodiment can be used as a generator that performs power generation in the photovoltaic power generation system of the sixth embodiment. The photovoltaic power generation system of the embodiment generates electricity using solar-cell modules and, concretely, includes a solar cell module that generates electricity, an element for converting the generated electricity, and either a storage element for the generated electricity or a load element that consumes the generated electricity. FIG. 15 shows a schematic configuration of the photovoltaic power generation system 400 of the embodiment. The photovoltaic power generation system of FIG. 15 includes a solar cell module 401 (300), a converter 402, a storage battery 403, and a load 404. Either the storage battery 403 or the load 404 may be omitted. The load 404 may also be configured to utilize the electrical energy stored in the storage battery 403. The converter 402 is a device that includes electric circuits or elements that perform power conversion such as voltage conversion or DC-AC conversion; for example, a DC-DC converter, a DC-AC converter, an AC-AC converter, etc. The configuration of the converter 402 may be chosen appropriately according to the generated voltage and the configurations of the storage battery 403 and the load 404.

The solar cells included in the solar-cell module 401 receive light, generate electricity, and the electrical energy is converted by the converter 402 and then either stored in the storage battery 403 or consumed by the load 404. It is preferable to provide the solar cell module 401 with a sun-tracking drive mechanism that always orients the solar-cell module toward the sun, a light-concentrating element that concentrates sunlight, or other devices that improve conversion efficiency. As a load 404, an electrolyzer that performs water electrolysis, CO₂ electrolysis, ammonia electrolysis, ammonia synthesis, etc., may be used.

The solar-power generation system 400 is preferably used for real estate such as residences, commercial facilities, factories, etc., or for movable property such as vehicles, aircraft, electronic devices, etc. By employing a solar cell having excellent conversion efficiency in the solar-cell module, an increase in the amount of generated electricity can be expected.

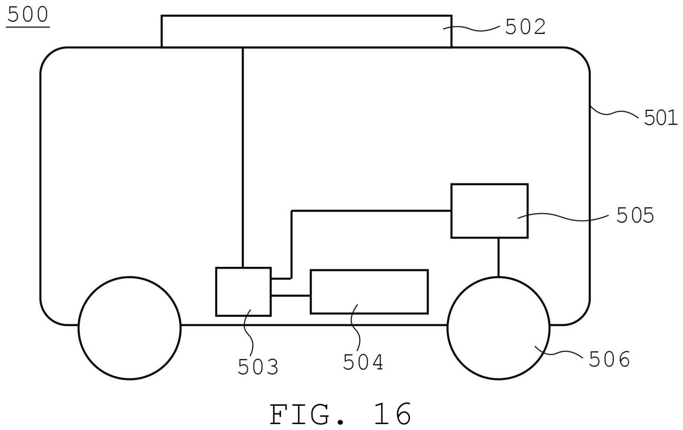

An example of use of the photovoltaic power generation system 400 is a vehicle. FIG. 16 shows a conceptual diagram of the configuration of a vehicle 500. The vehicle 500 includes a body 501, a solar cell module 502 (401), a power-conversion device 503, a storage battery 504, a motor 505, and tires (wheels) 506. The power generated by the solar cell module 502, which is provided on the upper part of the body 501, is converted by the power-conversion device 503 and either charges the storage battery 504 or is consumed by a load such as the motor 505. By using the power supplied from the solar cell module 502 or the storage battery 504, the motor 505 rotates the tires (wheels) 506, thereby moving the vehicle 500. The solar cell module 502 may consist solely of a first solar-cell module having the solar cell 100 of the third embodiment; it need not be a multi-junction type. When a transmissive solar cell module 502 is adopted, in addition to the upper side of the body 501, it is also preferable to use the solar cell module 502 as a power-generating window on the side of the body 501.

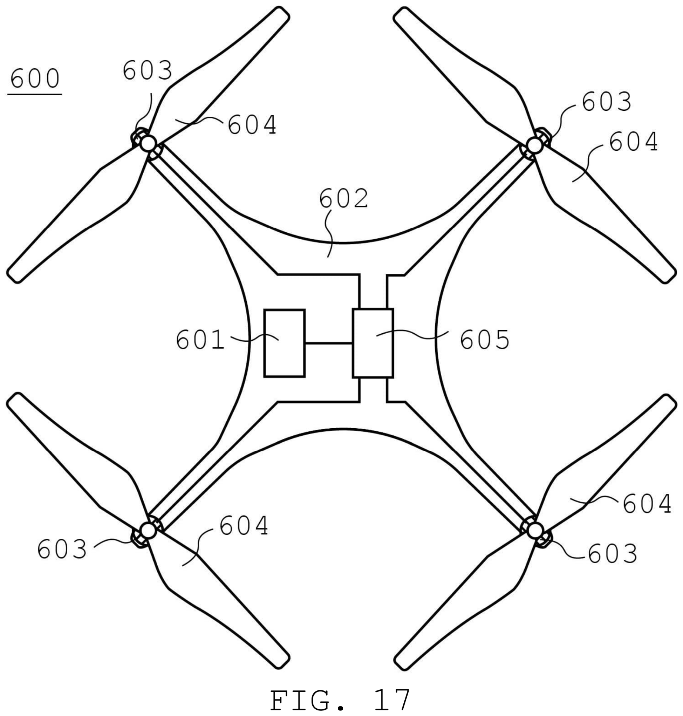

Another example of use of the photovoltaic power generation system 400 is a drone (quadcopter). The drone uses the solar cell module 401. The configuration of the drone according to the present embodiment is briefly described using the schematic diagram of the drone 600 shown in FIG. 17. The drone 600 includes a solar-cell module 601 (401), a frame 602, a motor 603, rotors 604, and a control unit 605. The solar cell module 601, the motor 603, the rotors 604 and the control unit 605 are mounted on the frame 602. The control unit 605 converts or adjusts the power output from the solar-cell module 601. The motor 603 uses the power output from the solar cell module 601 to rotate the rotors 604. By providing the drone 600 with the solar cell module 601 of the embodiment, a drone that can fly using a larger amount of power is provided.

Below, the invention is described in more detail based on examples, but the invention is not limited to the following examples.

### (Example A1 (Ex. A1))

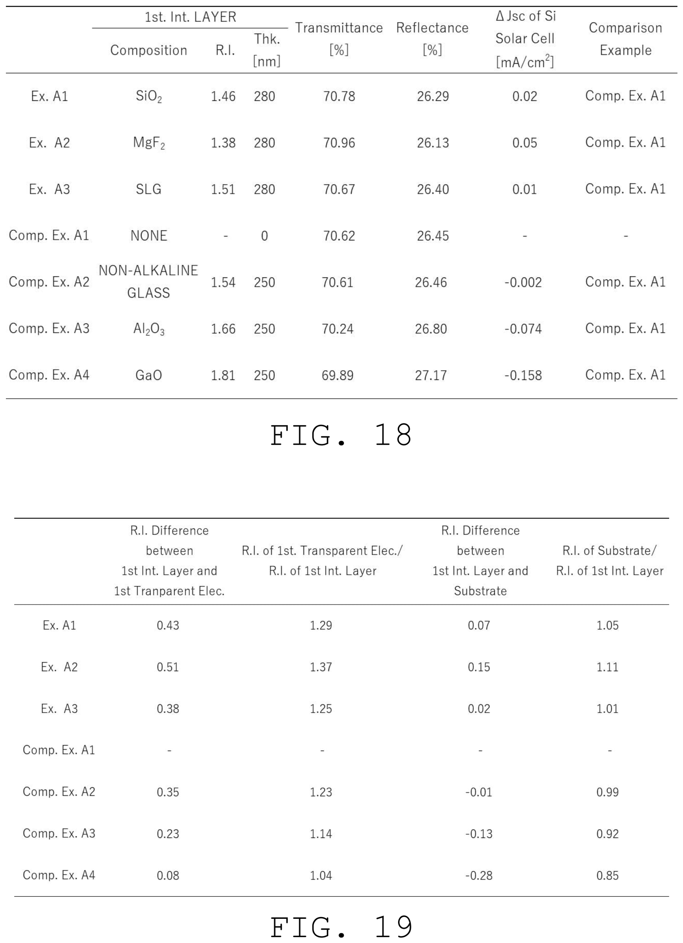

Simulations are performed under the following conditions. Because the simulation evaluates the transmittance improvement obtained by using the first intermediate layer 2A rather than the power-generation characteristics, only a portion of the solar cell 100 that does not generate power was modeled. The simulated layered member consists of the substrate 1, the first intermediate layer 2A, the first transparent electrode 3, and the p-type light-absorbing layer 5 in that order. The simulation calculated the transmittance and reflectance of light in the wavelength range from 600 nm to 1000 nm. Example A1 performed the simulation under the conditions listed below. The simulation conditions and the transmittance and reflectance in the 600 nm-1000 nm wavelength range are shown in the table of FIG. 18. In addition, the change in short-circuit current density (ΔJsc mA/cm²) of a Si solar cell that would generate electricity with the light transmitted through the simulated structure, corresponding to the change in transmittance, is also shown in the table of FIG. 18.

Substrate 1: ultra clear glass (thickness 0.5 mm (Thk. =0.5 mm), refractive index 1.53 (R.I. = 1.53))
First intermediate layer 2A: SiO₂ (thickness 280 nm, refractive index 1.46)
First transparent electrode 3: on the side of the first intermediate layer 2A, ITO (In : Sn = 80 : 20, thickness 100 nm, refractive index 1.89); on the side of the p-type light-absorbing layer 5, ATO (Sn : Sb = 98 : 2, thickness 50 nm, refractive index 1.95)
p-type light-absorbing layer 5: Cu₂O layer (thickness 6.0 µm, refractive index 2.87)
Simulation method: The transmittance and reflectance of the above layered member were simulated using e-ARC (a thin-film solar-cell characteristic simulation software developed by the National Institute of Advanced Industrial Science and Technology). The change in short-circuit current density of a Si solar cell, estimated from the change in transmittance relative to a reference transmittance, was also evaluated.

### (Examples A1-A3 and Comparative Example A1-A3 (Comp. Ex A1-A3))

As shown in the table of FIG. 18, simulations were performed while varying the refractive index of the first intermediate layer 2A. The simulation conditions and the transmittance and reflectance in the wavelength range of 600 nm to 1000 nm are presented in the table of FIG. 18. "SLG" denotes soda-lime glass. The relationship between the refractive index of the first intermediate layer 2A and the refractive index of the first transparent electrode 3 is shown in the table of FIG. 19. For example, the refractive index of the first intermediate layer 2A can be changed by altering its composition. The change in short-circuit current density (ΔJsc) for Example A1 is expressed as the change from the Jsc of Comparative Example A1, which serves as the reference.

### Reference Example A1

On a ultra clear glass substrate 1 (thickness 0.5 mm), a rear-side first transparent electrode 3 was formed by depositing, on the side that contacts the glass, an ITO layer (In : Sn = 80 : 20, thickness 150 nm) and an ATO layer (Sn : Sb = 98 : 2, thickness 100 nm). On top of the ATO, a Cu₂O layer having a thickness of 6 µm was deposited as the p-type light-absorbing layer 5 by sputtering in an O₂/Ar atmosphere. After forming the p-type light-absorbing layer 5, a Ga₂O₃ film having a thickness of 10 nm was deposited as the n-type layer 6 (first n-layer). On the Ga₂O₃, a second n-layer consisting of a ZnSnO film (Zn : Sn = 80 : 20) with a thickness of 14 nm was deposited. Finally, a AZO layer (ZnO : Al) having a thickness of 0.1 µm was deposited as the second transparent electrode 7, thereby obtaining solar cell 100. The solar cell of Reference Example A1 has the same configuration as Example A1 except that the n-type layer 6 and the second transparent electrode 7 are added.

A solar-simulator that emulates an AM 1.5 G light source was used; under this illumination the reference Si cell was adjusted to one-sun intensity. Measurements were carried out at atmospheric pressure and at a room temperature of 25 °C. The voltage was swept and the short-circuit current density Jsc (current divided by cell area) was measured. When the horizontal axis (voltage) and the vertical axis (current density) intersect, the point is the open-circuit voltage Voc. On the measured J-V curve, the product of voltage and short-circuit current density was calculated; the point where this product is maximum is designated Vmpp and Jmpp (maximum-power point). The fill factor is obtained from FF = (Vmpp × Jmpp) / (Voc × Jsc), and the conversion efficiency is obtained from Eff. = Voc × Jsc × FF. The transmittance of light in the wavelength band of 600 nm to 1000 nm for Reference Example A1 can be measured. Even when the first intermediate layer 2A is placed between the substrate 1 and the first transparent electrode 3, power generation occurs. In the following examples, the first intermediate layer 2A is also evaluated after having determined suitable refractive index values and thicknesses by simulation.

Example A evaluated the effect of changing the material of the first intermediate layer 2A. When a first intermediate layer 2A whose refractive index is lower than that of the substrate 1 and also lower than that of the first transparent electrode 3 is used, the transmittance increases and the reflectance decreases compared with an example that does not employ a first intermediate layer 2A. Conversely, when a transparent insulating material whose refractive index is higher than that of the substrate 1 but lower than that of the first transparent electrode 3 is used as the first intermediate layer 2A, the transmittance decreases and the reflectance increases compared with an example that does not employ a first intermediate layer 2A. The transmittance varied proportionally with the difference between the refractive index of the substrate 1 and the refractive index of the first intermediate layer 2A. A larger difference between the refractive index of the first transparent electrode 3 and the refractive index of the first intermediate layer 2A resulted in a higher transmittance, i.e., the refractive index difference reduced reflection.

### (Example B)

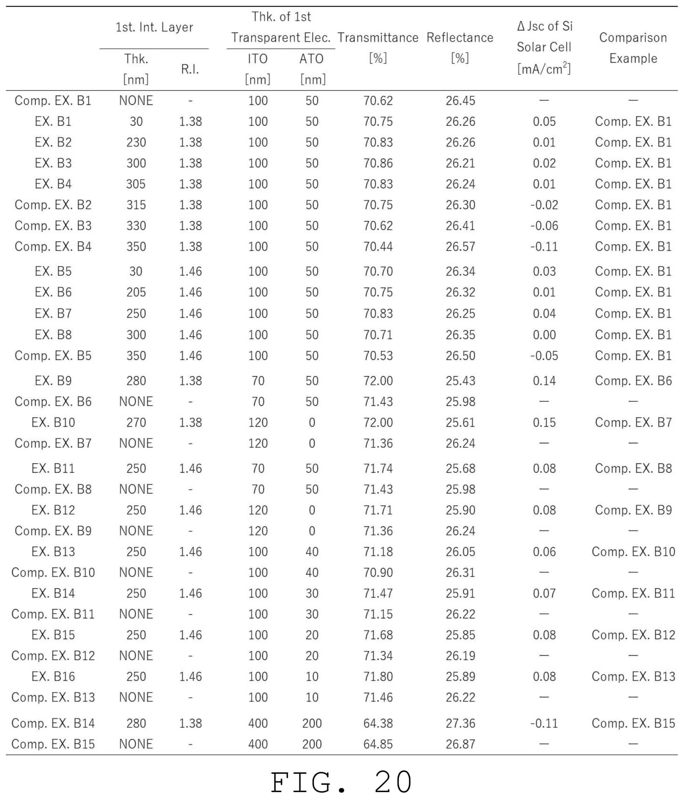

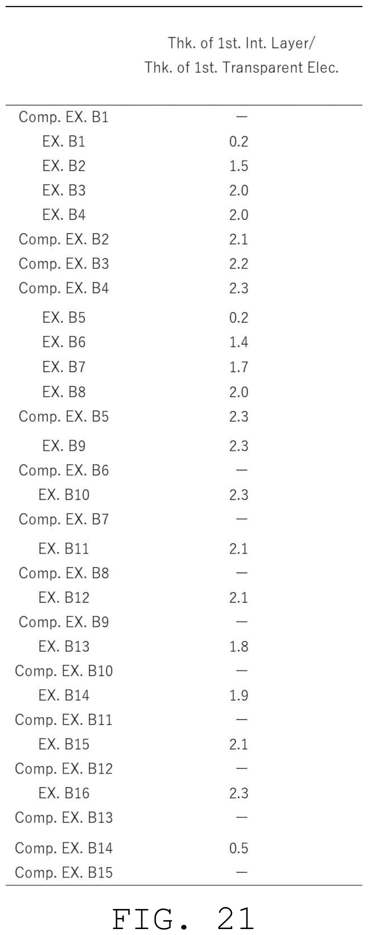

Example B performed simulations in the same manner as Example A except that the thickness of the first intermediate layer 2A and/or the thickness of the first transparent electrode 3 were varied. The simulation conditions and the simulation results are shown in the table of FIG. 20. The values of the thickness of the first intermediate layer 2A and the thickness of the first transparent electrode 3 used in Example B are shown in the table of FIG. 21.

### (Examples B1-B8 and Comparative Examples B1-B5)

When MgF₂ (refractive index 1.38) was used as the first intermediate layer 2A, as well as when SiO₂ (refractive index 1.46) was used as the first intermediate layer 2A, the transmittance of the layered member was improved and the increase in Jsc of the Si solar cell was contributed to.

### (Examples B9-B10 and Comparative Examples B6-B7)

Changing the thickness of the first transparent electrode 3 also resulted in improved transmittance and contributed to an increase in the Jsc of the Si solar cell.

### (Examples B11-B16 and Comparative Examples B8-B13)

When the thickness of the first transparent electrode 3 was varied, the transmittance was improved in the same manner as in Example B7, and the Jsc of the Si solar cell was increased.

### (Comparative Examples B14-B15)

When the first transparent electrode 3 was extremely thick, the introduction of the first intermediate layer 2A caused a decrease in transmittance.

### (Example C)

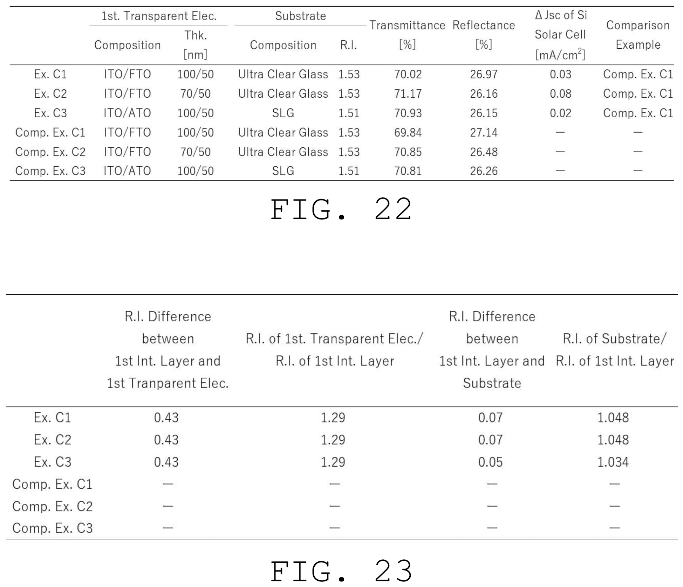

Example C performed simulations in the same manner as Example A except that one or more of the following were changed: the type of substrate 1, the type of first transparent electrode 3, and the thickness of the first transparent electrode 3. Comparative Examples C1-C3 were simulated where the layered members do not include any intermediate layers, including the first intermediate layer 2A. The simulation conditions and the simulation results are shown in the table of FIG. 22. The ratios of refractive indices and the differences of refractive indices used in Example C are shown in the table of FIG. 23. Even when the type of substrate 1, the type of first transparent electrode 3, or the thickness of the first transparent electrode 3 was changed, the inclusion of the first intermediate layer 2A contributed to an increase in transmittance, a decrease in reflectance, and an increase in the Jsc of the Si solar cell.

### (Example D)

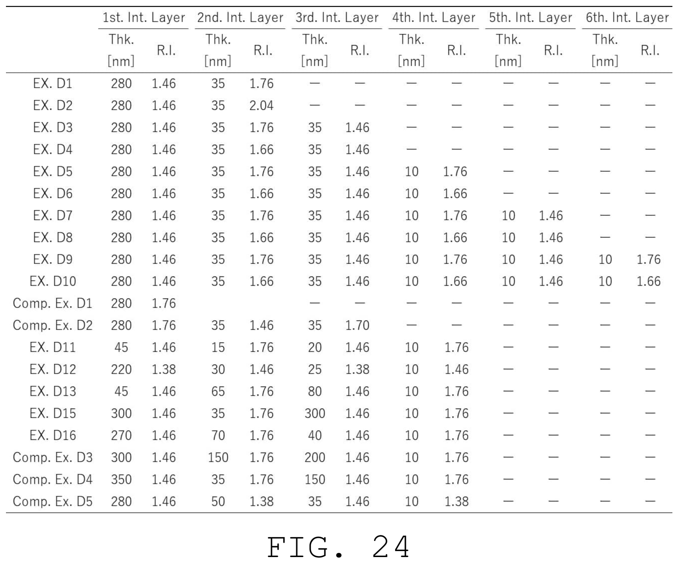

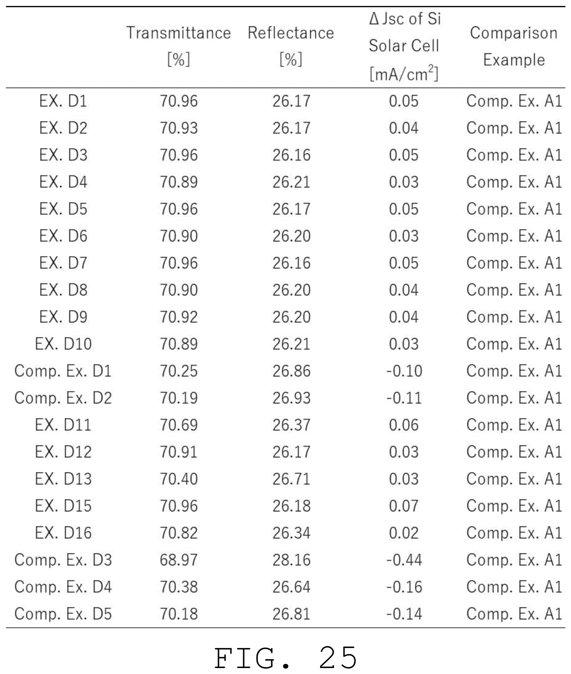

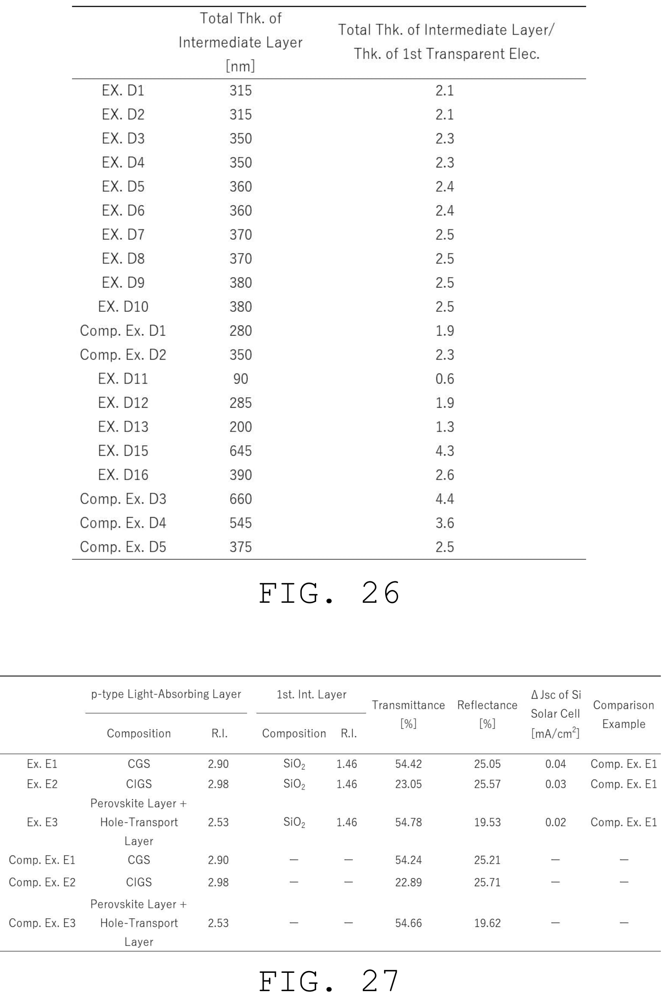

Example D evaluated multilayer intermediate layers by varying, in addition to the parameters of Example A, one or more of the following: the number of intermediate-layers, the (total) thickness (Thk.) of the intermediate layers, and the refractive index (R.I.) of the intermediate layers. The simulation conditions are listed in the table of FIG. 24, and the simulation results are listed in the table of FIG. 25. The ratio of the total intermediate-layer thickness (sum) to the thickness of the first transparent electrode 3 is shown in the table of FIG. 26. When a high-index second intermediate layer 2B was introduced, or when several low-index intermediate layers (first, third, fifth) and high-index intermediate layers (second, fourth, sixth) were alternately stacked while satisfying the refractive-index relations, the transmittance was improved. Conversely, when a material having a higher refractive index than the substrate 1 was placed on the side of the first transparent electrode 3 and a low-index first intermediate layer was placed on the substrate 1 side, the transmittance decreased even when many intermediate layers were stacked. In all of the examples, the introduction of intermediate layers altered the optical transmittance of the stacked portion and increased the Jsc of the Si solar cell.

### (Example E)

Example E performed simulations in the same manner as Example A except that the generation layer (the p-type light-absorbing layer) was changed. The simulation conditions and the results are shown in the table of FIG. 27. When the p-type light-absorbing layer 5 was replaced with a CGS layer, a CIGS layer, or a perovskite-type solar-cell layer, the first intermediate layer 2A still contributed to an improvement in transmittance.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

Some elements are expressed only by element symbols thereof.

## Claims

1. A layered body (10) comprising:
a substrate (1) ;
a first intermediate layer 2A provided on the substrate (1); and
a first transparent electrode (3) provided on the first intermediate layer (2A), wherein
the refractive index of the first intermediate layer (2A) is lower than the refractive index of the substrate (1), and
the refractive index of the first intermediate layer (2A) is lower than the refractive index of the first transparent electrode (3).

2. The layered body (10) according to claim 1, wherein
the first intermediate layer (2A) is electrical insulation.

3. The layered body (10) according to claim 1 or 2, wherein
the thickness of the first intermediate layer (2A) is 0.2 times or more and 2.5 times or less the thickness of the first transparent electrode (3).

4. The layered body (10) according to any one of claims 1 to 3, wherein
the thickness of the first intermediate layer (2A) is 1.4 times or more and 2.1 times or less the thickness of the first transparent electrode (3).

5. The layered body (10) according to any one of claims 1 to 4, wherein
the thickness of the first intermediate layer (2A) is 30 nm or more and 310 nm or less.

6. The layered body (10) according to any one of claims 1 to 5, wherein
the thickness of the first intermediate layer (2A) is 200 nm or more and 305 nm or less.

7. The layered body (10) according to any one of claims 1 to 6, wherein
the refractive index of the first intermediate layer is 1.30 or more and 1.50 or less.

8. The layered body (10) according to any one of claims 1 to 7, wherein
the first intermediate layer (2A) is primarily composed of SiO₂ or MgF₂.

9. The layered body (10) according to any one of claims 1 to 8, wherein
the refractive index of the first transparent electrode (3) is 1.1 times or more and 1.5 times or less the refractive index of the first intermediate layer (2A).

10. The layered body (10) according to any one of claims 1 to 9, wherein
the refractive index of the substrate (1) is 1.01 times or more and 1.30 times or less the refractive index of the first intermediate layer (2A).

11. The layered body (10) according to any one of claims 1 to 10, wherein
the difference between the refractive index of the first intermediate layer (2A) and the refractive index of the first transparent electrode (3) is 0.36 or more and 0.60 or less.

12. The layered body (10) according to any one of claims 1 to 11, wherein
the difference between the refractive index of the first intermediate layer (2A) and the refractive index of the substrate (1) is 0.01 or more and 0.25 or less.

13. The layered body (10) according to any one of claims 1 to 12, wherein
the refractive index of the first transparent electrode (3 is 1.1 times or more and 1.4 times or less the refractive index of the substrate (1).

14. The layered body (10) according to any one of claims 1 to 13,
further comprising a second intermediate layer (2B) disposed between the substrate (1) and the first intermediate layer (2A), wherein
the refractive index of the second intermediate layer (2B) is higher than the refractive index of the substrate (1)and
the refractive index of the second intermediate layer (2B) is higher than the refractive index of of the first intermediate layer (2A).

15. An electronic device (11) comprising:
the layered body (10) according to any one of claims 1 to 14; and
a liquid-crystal layer (20, a light-emitting layer (22), or a semiconductor layer (23) provided on the layered body (10), wherein
the semiconductor layer (23) includes a compound semiconductor.

16. A solar cell (100) comprising:
the layered body (10) according to any one of claims 1 to 14;
a p-type light-absorbing layer (5) provided on the layered body (10);
an n-type layer (6) provided on the p-type light-absorbing layer (5); and
a second transparent electrode (7) formed on the n-type layer (6), wherein
the p-type light-absorbing layer (5) is a compound-semiconductor layer.

17. The solar cell (100) according to claim 16, wherein
the p-type light-absorbing layer (5) includes a cuprous-oxide compound.
